# EUROPEAN PATENT APPLICATION

(11) **EP 2 071 633 A1**
(43) Date of publication of application: **17.06.2009**
(21) Application number: 07805797.3
(22) Date of filing: 31.08.2007
(51) Int. Cl.: H01L 31/04

(54) **TRANSPARENT ELECTRODE SUBSTRATE FOR SOLAR CELL**

(30) Priority: 31.08.2006 JP 2006235952
(71) Applicant: National Institute of Advanced Industrial Science and Technology, Tokyo 100-8921 (JP); The Nippon Synthetic Chemical Industry Co., Ltd., Osaka-shi, Osaka 531-0076 (JP)
(72) Inventor: MATSUI, Takuya, Tsukuba-shi, Ibaraki 305-8568 (JP); MASUDA, Atsushi, Tsukuba-shi, Ibaraki 305-8568 (JP); KATSUMA, Katsuhiko, Osaka-shi, Osaka 531-0076 (JP); HAYAKAWA, Seiichirou, Osaka-shi, Osaka 531-0076 (JP)
(74) Representative: Kuhnen & Wacker
(86) International application number: PCT/JP2007/000942
(87) International publication number: WO 2008/026322

(57) **Abstract**

It relates to a transparent electrode substrate for a solar cell comprising a resin film [I] 1 and a film 2 comprising a metal oxide fabricated thereon, wherein the resin film [I] 1 is a fabricated body obtained by curing a photocurable composition and having an unevenness on the side of the resin film [I] 1 on which the film 2 comprising a metal oxide is fabricated

## Description

### Technical Field

The present invention relates to a transparent electrode substrate for a solar cell comprising a resin and a film comprising a metal oxide fabricated thereon. More particularly, the invention relates to a transparent electrode substrate for a solar cell, which has excellent appearance properties free from warpage, waviness and the like, and additionally has excellent optical properties and electric properties.

### Background Art

In recent years, a solar cell is noted as environmental measures such as the prevention of global warming, and energy measures such as fossil fuel substitute. At present, a panel using a substrate made of glass is generally used as a solar cell. However, the glass has a risk of breakage, and additionally the glass itself is heavy. Therefore, for example, there is the limit in reduction of costs such that when a solar cell panel is fixed on a roof, special reinforcement is required.

Consequently, the movement of substituting a glass substrate of a solar cell panel with a substrate comprising a resin film is recently active.
When a resin film is used, the resin film is difficult to break and is safe, can achieve great reduction in weight and thickness, and can increase the area. Furthermore, the resin film can be manufactured by roll-to-roll, and reduction in costs can be expected thereby. Additionally, the resin film has flexibility, and therefore has the effect that the resin film can be applied to a curved surface.

A solar cell generally has a constitution such that a transparent electrode comprising metal oxide such as zinc oxide, tin oxide or indium-tin oxide, a photoelectric conversion layer selected from amorphous silicon, crystalline silicon, a metal compound or the like, and a back reflective electrode selected from gold, silver, copper, platinum, palladium, aluminum, titanium or the like are fabricated on a substrate in this order (called superstrate-type) or in the reverse order (called substrate-type). Of those, a solar cell using amorphous silicon in the photoelectric conversion layer is particularly noted in reduction in film thickness and reduction in costs. A dry process is generally used as a production process of a solar cell using amorphous silicon. For example, the following process is used. A transparent electrode is deposited on a substrate by a sputtering method to prepare a substrate with a transparent electrode, amorphous silicon is deposited by a CVD method (chemical vapor deposition), and a back reflective electrode is deposited by a sputtering method. In general, it is the actual situation that those processes are carried out at a temperature of 150°C or higher in order to develop performance.

Needless to say, in the solar cell, photoelectric conversion efficiency is important and a deposition method having excellent photoelectric conversion material and conversion efficiency is important. For the improvement of conversion efficiency, technologies regarding a metal electrode and a transparent electrode are also important. In particular, the transparent electrode and its surface shape greatly affect the conversion efficiency.

It is essential for the transparent electrode to have low resistance in order to increase outside extraction efficiency of electric power generated, and it is further required for the transparent electrode to have transparency which sufficiently transmits sunlight.
To make the transparent electrode to have low resistance and have transparency, it is desired that metal oxide is deposited at high temperature to promote crystal growth.

However, in the case of using a resin film, when the resin film is deposited at high temperature, problems arise such that the film discolors to decrease light transmittance, warpage and waviness are generated in a substrate with a transparent electrode obtained due to deficiency of heat resistance, and cracks are generated in the transparent electrode due to difference in linear expansion coefficient between the transparent electrode and the resin film.

Furthermore, volatile gas is generated from a resin film as temperature becomes higher, and there is a tendency that a homogeneous transparent electrode film cannot be fabricated.
Therefore, the resin film is required to have heat resistance such that coloration and deformation are not occurred even at high temperature, to have low linear expansion and less generation of a volatile gas.
To cope with those requirements, a polyester film and a cyclic polyolefm film are proposed as a resin film for a solar cell (for example, see Patent Documents 1 to 3).

Additionally, the surface shape of the transparent electrode is important to improve photoelectric conversion efficiency. To efficiently transmit light received to a photoelectric conversion layer, it is desired that the shape of the surface of the transparent electrode which is a boundary to the photoelectric conversion layer is a structure which is liable to induce light scattering. That is, it is necessary that the surface of the transparent electrode is controlled to appropriate root mean square of surface roughness (RMS roughness). When the surface roughness is controlled, light scattering is generated when sunlight passes through the transparent electrode, and light path length in the photoelectric conversion layer gets longer. Therefore, light can effectively be utilized, and as a result, photoelectric conversion efficiency of a solar cell is excellent. Excessive increase in surface roughness leads to cracks and the like of the photoelectric conversion layer, which is not preferred.

In the case of using a glass substrate, a method for controlling surface roughness is generally a method of making the surface of a transparent electrode comprising metal oxide fabricated on the glass substrate rough in a fine uneven shape, thereby increasing light scattering. In general, the uneven shape is called a texture. At present, a method of fabricating the texture by controlling crystal growth of metal oxide when the metal oxide is deposited on a glass at high temperature is used.

This method generally requires deposition at high temperature of 300°C or higher for crystal growth of metal oxide, and this method is difficult to apply to a resin film. For this reason, in the case of using a resin film as a substrate, a method of fabricating a texture on a substrate itself and then depositing metal oxide is proposed as a substitute method of texture formation (for example, see Patent Documents 4 to 6).

Patent Document 1: JP-A-58-194377
Patent Document 2: JP-A-2001-274434
Patent Document 3: JP-A-2002-261311
Patent Document 4: JP-A-2003-298084
Patent Document 5: JP-A-2003-298085
Patent Document 6: JP-A-2003-298086

### Disclosure of the Invention

### Problems that the Invention is to Solve

However, the resin films disclosed in Patent Documents 1 to 3 above are still insufficient in heat resistance. Therefore, those resin films deform at high temperature, and a transparent electrode having low resistance sufficient to satisfy the performance recently required could not be fabricated by the resins. Furthermore, the resin film is colored when heated. Therefore, there was the problem that light transmittance in a region of from visible light to near infrared light, which is important for photoelectric conversion of a solar cell is decreased.

Furthermore, in the method disclosed in Patent Document 4 above, a substrate and a texture must be fabricated separately, resulting in complicated process. This becomes a factor of increase in cost. Furthermore, a two layer structure of a substrate and a texture is fabricated, and as a result, warpage and waviness were liable to be generated. The methods disclosed in Patent Documents 5 and 6 above had the problem that because a resin film is prepared and a texture is then fabricated by thermal transfer, the process becomes complicated, and thermal deformation such as warpage and waviness is generated at the time of transferring, similar to the above. Furthermore, the methods disclosed in Patent Documents 4 to 6 above had the problem that it is difficult to transfer the texture in a matrix form. Additionally, adhesion between a resin film and a texture layer is insufficient, and there was the possibility that the texture layer is peeled from the resin film.

Accordingly, under the above background, the present invention has an object to provide a transparent electrode substrate for a solar cell, which has no coloration and deformation, has excellent appearance properties free from warpage and waviness, has low resistance, and has excellent photoelectric conversion efficiency.

### Means for Solving the Problems

As a result of keen investigation to solve the above problems, the present inventors have found that when a fabricated body obtained by curing a photocurable composition, the fabricated body itself having a texture fabricated therein, is used as a resin film, coloration and deformation are not generated, excellent appearance properties free from warpage and waviness are obtained, low resistance is achieved, and excellent photoelectric conversion efficiency is achieved, and have completed the invention.

That is, the invention relates to a transparent electrode substrate for a solar cell comprising a resin film [I] and a film comprising a metal oxide fabricated thereon, wherein the resin film [I] is a fabricated body obtained by curing a photocurable composition, and the fabricated body has an unevenness on the side of the resin film [I] on which the film comprising a metal oxide is fabricated.

In the invention, it is preferred in heat resistance that the photocurable composition comprises a polyfunctional (meth)acrylate compound and a photopolymerization initiator.

In the invention, it is preferred in photoelectric conversion efficiency that the resin film [I] has a thickness of from 0.1 to 1 mm, and the unevenness of the resin film [I] is from 10 to 300 nm in terms of root mean square of surface roughness (RMS roughness) by AFM (atomic force microscope) measurement at 256 measurement points with a measurement range of 2 µm angle.

In the invention, it is preferred in heat resistance and shorter evacuation time at the time of deformation that the resin film [I] satisfies the following two requirements:
(1) a glass transition temperature is 150°C or higher, and
(2) a rate of saturated water absorption is 3% or less.

In the invention, it is preferred in resistance of the metal oxide that the resin film [I] satisfies the following two requirements:
(1) an average linear expansion coefficient at 50 to 150°C is 70 ppm/°C or less on, and
(2) a flexural modulus at 150°C is from 2 to 3 GPa.

In the invention, it is preferred in photoelectric conversion efficiency that the resin film [I] satisfies the following two requirements:
(1) a light transmittance at 550 nm of visible light is 85% or more, and
(2) a light transmittance at 1,000 nm of near infrared light is 85% or more.

In the invention, it is preferred in photoelectric conversion efficiency that the transparent electrode substrate satisfies the following two requirements:
(1) a light transmittance at 550 nm of visible light is 80% or more, and
(2) a light transmittance at 1,000 nm of near infrared light is 80% or more.

In the invention, it is preferred in photoelectric conversion efficiency that the root mean square of surface roughness (RMS roughness) by AFM (atomic force microscope) measurement at 256 measurement points with a measurement range of 2 µm angle on the surface of the film comprising a metal oxide is from 10 to 300 nm.

In the invention, it is preferred that a gas barrier film having a thickness of from 5 to 500 nm and comprising a silicon oxide or silicon nitride as a main component is fabricated on at least one side of the resin film [I].

It is preferred that a lifting amount when the transparent electrode substrate of the invention is placed on a flat platen is 5 mm or less.

In the invention, it is preferred that the resin film [I] is obtained by the following processes: (1) facing a pair of plate-like molds at a given distance, in which an active energy ray passes through at least one mold and at least one mold has a fine unevenness of from 10 to 300 nm in terms of root mean square of surface roughness (RMS roughness) by AFM (atomic force microscope) measurement at 256 measurement points with a measurement range of 2 µm angle, and sealing a surrounding part thereof to fabricate a mold cavity, and (2) injecting a photocurable composition into the cavity, irradiating the photocurable composition with the active energy ray through the plate-like mold to cure the photocurable composition, and then demolding a fabricated body of the photocured resin from the plate-like mold.

In the invention, it may further comprise a resin film [II] laminated on the resin film [I] on the side opposite to the film comprising a metal oxide. In this embodiment, it is preferred that the resin film [I] has a thickness of from 0.1 to 100 µm, the resin film [II] has a thickness of from 10 to 400 µm, the resin film [II] has a thermal deformation temperature of 150°C or higher, the resin film [II] is a polyvinyl alcohol film, and a total light transmittance is 80% or more.
Furthermore, in this embodiment, it is preferred that a gas barrier film having a thickness of from 5 to 500 nm and comprising a silicon oxide or silicon nitride as a main component is fabricated on at least one side of a laminate [A] comprising the resin film [I]/resin film [II].
Furthermore, it is preferred that the laminate [A] comprising the resin film [I]/resin film [II] is obtained by adding the photocurable composition on a plate-like support having an unevenness of from 10 to 300 nm in terms of root mean square of surface roughness (RMS roughness) by AFM (atomic force microscope) measurement at 256 measurement points with a measurement range of 2 µm angle, laminating the resin film [II] thereon, irradiating the photocurable composition with an active energy ray through the resin film [II] and/or the plate-like support to cure the photocurable composition, and removing the plate-like support.

### Advantage of the Invention

The transparent electrode substrate for a solar cell of the invention has no coloration and deformation, has excellent appearance properties free from warpage and waviness, has low resistance, and has excellent effect in photoelectric conversion efficiency, and is therefore useful as an electrode substrate of a solar cell.

### Brief Description of the Drawings

Fig. 1 is a sectional view showing a constitution of a first embodiment of a solar cell substrate according to the invention.
Fig. 2 is a sectional view showing a constitution of a second embodiment of a solar cell substrate according to the invention.

### Description of Reference Numerals and Signs

- 1: Resin film [I]
- 2: Metal oxide film (gallium-doped zinc oxide)
- 3: Photoelectric conversion layer
- 4: Back reflective electrode layer
- 5: Resin film [II]
- 31: p-type layer
- 32: i-type layer
- 33: n-type layer
- 41: Transparent conductive film (gallium-doped zinc oxide)
- 42: Back metal electrode (silver)

### Best Mode for Carrying Out the Invention

The invention is described in detail below.
In the invention, the term "(meth)acrylate" is a generic term of acrylate and methacrylate, and the term "(meth)acryl" is a generic term of acryl and methacryl.

The transparent electrode substrate for a solar cell of the invention comprises a resin film [I] and a film comprising a metal oxide fabricated thereon, wherein the resin film [I] is a fabricated body obtained by curing a photocurable composition, and the fabricated body has unevenness on the side of the resin film [I] on which the film comprising a metal oxide is fabricated.

The resin film [I] used in the invention is a fabricated body obtained by curing a photocurable composition.
Use of the photocurable composition enables a resin film with a texture to integrally fabricate, and additionally can produce the film by a process simpler than the conventional texture fabricating method. The resin film [I] is hereinafter referred to as a texture layer.

The photocurable composition used in the invention is not particularly limited, but a polyfunctional (meth)acrylic photocurable composition is preferably used. Use of the polyfunctional (meth)acrylic photocurable composition can obtain a texture layer having excellent heat resistance.

The polyfunctional (meth)acrylic photocurable composition according to the invention contains a polyfunctional (meth)acrylate compound and a photopolymerization initiator. The resin film [I] (texture layer) is obtained by photocuring the photocurable composition.

The polyfunctional (meth)acrylate compound includes bifunctional (meth)acrylate compounds, trifunctional or more (meth)acrylate compounds, and the like.

Examples of the bifunctional (meth)acrylate compound include, for example, aliphatic compounds such as ethylene glycol di(meth)acrylate, diethylene glycol di(meth)acrylate, tetraethylene glycol di(meth)acrylate, polyethylene glycol di(meth)acrylate, propylene glycol di(meth)acrylate, dipropylene glycol di(meth)acrylate, polypropylene glycol di(meth)acrylate, butylene glycol di(meth)acrylate, neopentyl glycol di(meth)acrylate, 1,6-hexanediol di(meth)acrylate, glycerin di(meth)acrylate, pentaerythritol di(meth)acrylate, ethylene glycol diglycidyl ether di(meth)acrylate, diethylene glycol diglycidyl ether di(meth)acrylate, hydroxypivalic acid modified neopentyl glycol di(meth)acrylate, isocyanuric acid ethylene oxide modified di(meth)acrylate and 2-(meth)acryloyloxyethyl acid phosphate diester; alicyclic compounds such as bis(hydroxyl)tricyclo[5.2.1.0^{2,6}]decane=di(meth)acrylate, bis(hydroxy)tricyclo[5.2.1.0^{2,6}]decane=acrylate methacrylate, bis(hydroxymethyl)tricyclo[5.2.1.0^{2,6}]decane=di(meth)acrylate, bis(hydroxymethyl)tricyclo[5.2.1.0^{2,6}]decane=acrylate methacrylate, bis(hydroxy)pentacyclo[6.5.1.1^{3,6}.0^{2,7}.0^{9,13}]pentadecane=di(meth)acrylate, bis(hydroxy)pentacyclo[6.5.1.1^{3,6}.0^{2,7}.0^{9,13}]pentadecane=acrylate methacrylate, bis(hydroxymethyl)pentacyclo[6.5.1.1^{3,6}.0^{2,7}.0^{9,13}]pentadecane=di(meth)acrylate, bis(hydroxymethyl)pentacyclo[6.5.1.1^{3,6}.0^{2,7}.0^{9,13}]pentadecane=acrylate methacrylate, 2,2-bis[4-(β-(meth)acryloyloxyethoxy)cyclohexyl]propane, 1,3-bis((meth)acryloyloxymethyl)cyclohexane, 1,3-bis((meth)acryloyloxyethyl)cyclohexane, 1,4-bis((meth)acryloyloxymethyl)cyclohexane and 1,4-bis((meth)acryloyloxyethyl)cyclohexane; and aromatic compounds such as phthalic acid diglycidyl ester di(meth)acrylate, ethylene oxide modified bisphenol A (2,2'-diphenylpropane) type di(meth)acrylate and propylene oxide modified bisphenol A (2,2'-diphenylpropane) type di(meth)acrylate.

Examples of the trifunctional or more (meth)acrylate compound include, for example, aliphatic compounds such as trimethylolpropane tri(meth)acrylate, pentaerythritol tri(meth)acrylate, pentaerythritol tetra(meth)acrylate, dipentaerythritol penta(meth)acrylate, dipentaerythritol hexa(meth)acrylate, tri(meth)acryloyloxyethoxytrimethylol propane, glycerin polyglycidyl ether poly(meth)acrylate, isocyanuric acid ethylene oxide modified tri(meth)acrylate, ethylene oxide modified dipentaerythritol penta(meth)acrylate, ethylene oxide modified dipentaerythritol hexa(meth)acrylate, ethylene oxide modified pentaerythritol tri(meth)acrylate and ethylene oxide modified pentaerythritol tetra(meth)acrylate; and alicyclic compounds such as 1,3,5-tris(meth)acryloyloxymethylcyclohexane and 1,3,5-tris(meth)acryloyloxyethyloxymethyl)cyclohexane.

In addition to the above compounds, examples of the polyfunctional (meth)acrylate compound further include polyfunctional epoxy (meth)acrylate compounds, polyfunctional urethane (meth)acrylate compounds, polyfunctional polyester (meth)acrylate compounds, polyfunctional polyether (meth)acrylate compounds and the like.

Of those polyfunctional (meth)acrylate compounds, polyfunctional urethane (meth)acrylate compounds, bis(hydroxy)tricyclo[5.2.1.0^{2,6}]decane=di(meth)acrylate, bis(hydroxymethyl)tricyclo[5.2.1.0^{2,6}]decane=di(meth)acrylate, pentaerythritol tetra(meth)acrylate and trimethylolpropane tri(meth)acrylate are preferred in heat resistance and linear expansion coefficient of the resin film [I] (texture layer). Polyfunctional urethane (meth)acrylate compounds having an alicyclic structure, bis(hydroxy)tricyclo[5.2.1.0^{2,6}]decane=di(meth)acrylate and bis(hydroxymethyl)tricyclo[5.2.1.0^{2,6}]decane=di(meth)acrylate are further preferred in that curing shrinkage of the resin film [I] (texture layer) is suppressed and waviness is reduced, and combined use of those is particularly preferred.

The polyfunctional urethane (meth)acrylate compound preferably used in the invention is, for example, a compound obtained by reacting a polyisocyanate compound and a hydroxyl group-containing (meth)acrylate compound, according to need, using a catalyst such as dibutyltin dilaurate.

Specific examples of the polyisocyanate compound include, for example, aliphatic polyisocyanates such as ethylene diisocyanate and hexamethylene diisocyanate; polyisocyanate compounds having an alicyclic structure such as isophorone diisocyanate, bis(isocyanatomethyl)tricyclo[5.2.1.0^{2,6}]decane, norbomane isocyanatomethyl, 1,3-bis(isocyanatomethyl)cyclohexane, 1,4-bis(isocyanatomethyl)cyclohexane, bis(4-isocyanatocyclohexyl)methane, 2,2-bis(4-isocyanatocyclohexyl)propane, hydrogenated xylene diisocyanate, hydrogenated diphenylmethane diisocyanate and a trimeric compound of isophorone diisocyanate; and polyisocyanate compound having an aromatic ring such as diphenylmethane diisocyanate, phenylene diisocyanate, tolylene diisocyanate and naphthalene diisocyanate.

Specific examples of the hydroxyl group-containing (meth)acrylate compound include, for example, 2-hydroxyethyl (meth)acrylate, 2-hydrpxylpropyl (meth)acrylate, 2-hydroxybutyl (meth)acrylate, 2-hydroxy-3-(meth)acryloyloxypropyl (meth)acrylate, pentaerythritol tri(meth)acrylate, dipentaerythritol penta(meth)acrylate, dipentaerythritol tri(meth)acrylate and the like.

The polyfunctional urethane (meth)acrylate compounds obtained by the reaction of the polyisocyanate compound and the hydroxyl group-containing (meth)acrylate compound may be used by mixing two or more thereof. Of those reaction products, compounds having an alicyclic skeleton are preferred in water absorption, acrylate compounds are further preferred in curing rate, and bi- to nona-functional, particularly bi-to hexa-functional compounds are particularly preferred from the standpoints of heat resistance and flexural modulus.

The photocurable composition fabricating the resin film [I] (texture layer) according to the invention may contain a monofunctional (meth)acrylate compound to an extent such that the curability is not impaired. Examples of the monofunctional compound include, for example, aliphatic compounds such as ethyl (meth)acrylate, n-butyl (meth)acrylate, 2-hydroxyethyl (meth)acrylate, 2-hydroxypropyl (meth)acrylate, 4-hydroxybutyl (meth)acrylate, tetrahydrofurfuryl (meth)acrylate, 2-ethylhexyl (meth)acrylate and glycidyl (meth)acrylate; alicyclic compounds such as cyclohexyl (meth)acrylate, tert-butylcyclohexyl (meth)acrylate, tricyclodecyl (meth)acrylate, tricyclodecyloxymethyl (meth)acrylate, tricyclodecyloxyethyl (meth)acrylate, dicyclopentenyl (meth)acrylate, dicyclopentenyloxymethyl (meth)acrylate, dicyclopentenyloxyethyl (meth)acrylate, isonorbornyl (meth)acrylate, norbornyl (meth)acrylate, adamantyl (meth)acrylate, 2-methyl-2-adamantyl (meth)acrylate, 2-ethyl-adamantyl (meth)acrylate and 3-hydroxy-1-adamantyl (meth)acrylate; aromatic compounds such as benzyl (meth)acrylate; monofunctional epoxy (meth)acrylate compounds; monofunctional urethane (meth)acrylate compounds; monofunctional polyester (meth)acrylate compounds; and monofunctional polyether (meth)acrylate compounds.
Those monofunctional (meth)acrylate compounds may be used alone or as mixtures of two or more thereof.
Those monofunctional (meth)acrylate compounds are generally used in an amount of preferably 50 parts by weight or less, further preferably 30 parts by weight or less, and particularly preferably 20 parts by weight or less based on 100 parts by weight of the photocurable composition. Where the amount of the compound used is too large, heat resistance and mechanical strength of the fabricated body obtained tend to be decreased.

The photopolymerization initiator used in the invention is not particularly limited so long as it can generate radicals upon irradiation with active energy ray, and various photopolymerization initiators can be used. Examples of the photopolymerization initiator include benzophenone, benzoin methyl ether, benzoin propyl ether, diethoxyacetophenone, 1-hydroxycyclohexyl phenyl ketone, 2,6-dimethylbenzoyl diphenylphosphine oxide, 2,4,6-trimethylbenzoyl diphenylphosphine oxide and the like. Of those, photopolymerization initiators such as 1-hydroxycyclohexyl phenyl ketone and 2,4,6-trimethylbenzoyl diphenylphosphine oxide are particularly preferred. Those photopolymerization initiators may be used alone or as mixtures of two or more thereof.

Those photopolymerization initiators are generally used in an amount of preferably from 0.1 to 10 parts by weight, further preferably from 0.2 to 5 parts by weight, and particularly preferably from 0.2 to 3 parts by weight based on 100 parts by weight of the (meth)acrylate compound (the total amount of the polyfunctional (meth)acrylate compound and the monofunctional (meth)acrylate compound when the monofunctional (ineth)acrylate compound is contained). Where the amount of the photopolymerization initiator used is too small, the rate of polymerization is decreased, and polymerization tends to not proceed sufficiently. Where the amount thereof is too large, light transmittance of the resin film [I] (texture layer) tends to be decreased (yellowed), and furthermore, mechanical strength tends to be decreased.

A thermal polymerization initiator may be used in combination with the photopolymerization initiator.
As the thermal polymerization initiator, known compounds can be used, and examples thereof include hydroperoxides such as hydroperoxide, t-butyl hydroperoxide, diisopropylbenzene hydroperoxide and 1,1,3,3-tetramethylbutyl hydroperoxide; dialkyl peroxides such as di-t-butyl peroxide and dicumyl peroxide; peroxyesters such as t-butyl peroxybenzoate and t-butyl peroxy(2-ethylhexanoate); diacyl peroxide such as benzoyl peroxide; peroxycarbonates such as diisopropyl peroxycarbonate; and peroxides such as peroxyketal and ketone peroxide.

The photocurable composition used in the invention may appropriately contain auxiliary components such as antioxidants, ultraviolet absorbers, silane coupling agents, thickeners, antistatic agents, flame retardants, antiformers, colorants and various fillers, other than the above-described (meth)acrylate compound and photopolymerization initiator.

The antioxidant is effective to prevent deterioration such as color change of a substrate and decrease in mechanical strength during high temperature process. Specific examples of the antioxidant include compounds such as 2,6-di-t-butylphenol, 2,6-di-t-butyl-p-cresol, 2,4,6-tri-t-butylphenol, 2,6-di-t-butyl-4-s-butylphenol, 2,6-di-t-butyl-4-hydroxymethylphenol, n-octadecyl-β-(4'-hydroxy-3',5'-di-t-butylphenyl)propionate, 2,6-di-t-butyl-4-(N,N-dimethylaminomethyl)phenol, 3,5-di-t-butyl-4-hydroxybenzylphosphonate diethyl ester, 2,4-bis(n-octylthio)-6-(4-hydroxy-3',5'-di-t-butylanilino)-1,3,5-triazine, 4,4-methylene-bis(2,6-di-t-butylphenol), 1,6-hexanediol bis[3-(3,5-di-t-butyl-4-hydroxyphenyl)-propionate], bis(3,5-di-t-butyl-4-hydroxybenzyl)sulfide, 4,4'-di-thiobis(2,6-di-t-butylphenol), 4,4'-tri-thiobis(2,6-di-t-butylphenol), 2,2-thiodiethylenebis[3-(3,5-di-t-butyl-4-hydroxyphenyl)propionate], N,N'-hexamethylenebis-(3,5-di-t-butyl-4-hydroxyhydroxyhydrocinnamide, N,N'-bis[3-(3,5-di-t-butyl-4-hydroxyphenyl)propionyl]hydrazine, calcium (3,5-di-t-butyl-4-hydroxybenzyl)monoethyl phosphonate, 1,3,5-trimethyl-2,4,6-tris(3,5-di-t-butyl-4-hydroxybenzyl)benzene, tris(3,5-di-t-butyl-4-hydroxyphenyl)isocyanurate, tris(3,5-di-t-butyl-4-hydroxybenzyl)isocyanurate, 1,3,5-tris-2[3(3,5-di-t-butyl-4-hydroxyphenyl)propionyloxy] ethyl isocyanurate, tetrakis[methylene-3-(3',5'-di-t-butyl-4-hydroxyphenyl)propionate]methane and 3,5-di-t-butyl-4-hydroxybenzylphosphite diethyl ether. Those compounds may be used alone or as mixtures of two or more thereof. Of those, tetrakis[methylene-3-(3',5'-di-t-butyl- 4-hydroxyphenyl)propionate]methane is particularly preferred in that the effect of suppressing color tone is increased.

The ultraviolet absorber is effective to prevent deterioration of a solar cell due to outdoor direct sunlight. The ultraviolet absorber is not particularly limited so long as it is dissolved in the (meth)acrylate compound, and various ultraviolet absorbers can be used. Specifically, example thereof includes salicylic ester type, benzophenone type, triazole type, hydroxybenzoate type, cyanoacrylate type and the like ultraviolet absorbers. Those ultraviolet absorbers may be used by combining plural ultraviolet absorbers. Of those, benzophenone type or triazole type ultraviolet absorbers, specifically, (2-hydroxy-4-octyloxy-phenyl)phenyl methanone, 2-benzotriazol-2-yl-4-tert-octyl phenol and the like, are preferred from the viewpoint of compatibility with the (meth)acrylate compound. The content ratio of the ultraviolet absorber is preferably from 0.001 to 1 part by weight, and particularly preferably from 0.01 to 0.1 part by weight based on 100 parts by weight of the (meth)acrylate compound (the total amount of the polyfunctional (meth)acrylate compound and the monofunctional (meth)acrylate compound when the monofunctional (meth)acrylate compound is used). Where the content of the ultraviolet absorber is too small, light resistance of a solar cell tends to be decreased, and where the content is too large, curing of the photocurable composition takes much time, and there is a possibility that the composition cannot sufficiently be cured.

When the photocurable composition thus obtained is irradiated with active energy ray, preferably ultraviolet ray, the composition cures, thereby obtaining a fabricated body becoming the resin film [I] (texture layer).

The resin film [I] (texture layer) obtained in the invention is obtained by integrally fabricating at the time of fabricating the resin film [I] (fabricated body). This method is not a method of individually fabricating a texture on the smooth surface of a resin film, nor a method of preparing a resin film and then imparting a texture to the surface thereof by heat or pressure. A resin film with a texture (resin film [I]) is obtained at a time from the photocurable composition by light fabricating. Fabricating at one time greatly shortens the fabricating time, and simplifies the process. Additionally, because the resin film is a single plate, there is no problem on peeling generated when a resin film and a texture layer are individually fabricated, and warpage and waviness of the resin film can be reduced. Furthermore, because the resin film and the texture part are integrated, there are the merits that compositional difference does not exist and properties such as light transmittance are stable.

The resin film [I] can be obtained by integral fabricating as follows. A pair of plate-like molds, at least one mold being a mold through which active energy ray passes, are faced at a given distance, and the surrounding parts thereof are sealed to fabricate a mold cavity. The photocurable composition is injected in the cavity, and is irradiated with active energy ray through the plate-shape mold to cure the photocurable composition. The fabricated body of the photocurable resin is demolded from the plate-like molds. Thus, the resin film [I] can be produced. In this case, it is preferred that at least one of a pair of plate-like molds has fine unevenness. The fine unevenness is preferably from 10 to 300 nm, more particularly from 10 to 200 nm, and further preferably from 15 to 100 nm, in terms of the root mean square of surface roughness (RMS roughness) by AFM (atomic force microscope) measurement at 256 measurement points with a measurement range of 2 µm angle. Where the root mean square of surface roughness (RMS roughness) is too small, photoelectric conversion efficiency tends to be decreased. Where the root mean square of surface roughness (RMS roughness) is too large, cracks tend to be generated in the transparent electrode.

In the invention, the resin film can be produced by roll-to-roll continuous molding. In this case, a supporting resin film having a texture on the surface thereof may be used in place of the plate-like molds. In this case, the photocurable composition is supplied on a first supporting resin film to be delivered, a second resin film to be delivered at preferably the same speed in the same direction is laminated thereon, and the photocurable composition is irradiated with active energy ray to cure the composition. In this case, when the texture is given to one of the first or second supporting resin film in advance, the desired texture can be transferred to the resin film [I] by closely contacting this with the curing resin. Thus, the resin film [I] having the texture can be produced by integral fabricating.

The plate-like mold is not particularly limited, but a mold made of glass, metal or silicon is preferred from the point of view of surface smoothness, heat resistance and the like.
Specific examples of the plate-like mold include the commercially available products such as A180U80 and A110U80, manufactured by Asahi Glass Co., Ltd., comprising a glass and a metal oxide having fine unevenness fabricated thereon. A plate-like mold can be prepared by treating a glass with hydrofluoric acid or the like or spraying a powder to a glass by a sandblast method, thereby roughening the glass surface. Of those, the commercially available product A180U80, manufactured by Asahi Glass Co., Ltd., is preferred in that variation of surface roughness among rots is small. Furthermore, crystal silicon and metal plate, having a texture fabricated on the surface thereof, can be used.

In the invention, the glass plate used to fabricate the resin film [I] or a glass comprising a metal oxide laminated on the surface thereof has poor demoldability to the resin film [I]. Therefore, there is the possibility that after photocuring, the resin film [I] does not peel from the glass, and the glass breaks. For this reason, it is desired that a release agent is applied in advance to the surface of the glass, contacting the resin film [I]. By applying the release agent, the glass can be used repeatedly. The release agent is not particularly limited, but a fluorine release agent is preferred in demoldability. More preferred release agent is a silane coupling agent containing a fluorinated alkyl group from the point of view of repeat durability.

Examples of the fluorine release agent include OPTOOL DSX, manufactured by Daikin Industries, Ltd., CYTOP CTL-107M, manufactured by Asahi Glass Co., Ltd., EGC-1720 and EGC-1700, manufactured by Sumitomo 3M, and XC98-B2472, manufactured by GE Toshiba Silicone Co., Ltd. OPTOOL DSX, manufactured by Daikin Industries, Ltd., is preferred in demoldability and repeat durability.

In the case that the glass-made plate-like mold on which the metal oxide is laminated is used to fabricate the resin film [I], it is desired that a thin film comprising silicon oxide or silicon nitride as a main component is previously fabricated on the surface of the metal oxide in a thickness of from several nm to several ten nm in order to improve adhesion between the fluorine silane coupling agent and the metal oxide. This treatment fabricates chemical bond between the fluorine silane coupling agent and the thin film comprising silicon oxide or silicon nitride as a main component, thereby a semipermanent release film can be fabricated. In this case, to further increase adhesion, a fluorine silane coupling agent may be applied to the metal oxide surface through the thin film comprising silicon oxide or silicon nitride as a main component, followed by conducting a treatment under high temperature and high humidity (for example, under the conditions of 60°C and 90%) for several hours.

In the invention, the resin film [I] with a texture is produced by, for example, facing a plate-like mold and a plate-like mold with a texture, using a silicon plate having a thickness of from 0.1 to 1 mm, and preferably from 0.1 to 0.5 mm, as a spacer, injecting a photocurable composition in the mold, and irradiating with active energy ray, particularly ultraviolet ray.

In injecting the photocurable composition, the photocurable composition has a viscosity at 23°C of preferably from 5 to 5,000 mPa·s, and further preferably from 10 to 2,000 mPa·s. Where the viscosity is too low, when injecting the photocurable composition in the mold, leakage thereof from the mold is remarkable, and workability tends to remarkably deteriorate. Where the viscosity is too high, when injecting the photocurable composition in the mold, injecting speed is considerably slow, and the problem tends to arise on workability.

It is preferred that the ultraviolet irradiation is conducted at illuminance of from 20 to 1,000 mW/cm² and particularly from 50 to 500 mW/cm², and light intensity of from 1 to 20 J/cm² and particularly from 2 to 10 J/cm². After irradiation, the cured product obtained by demolding is heated in a vacuum oven at from 120 to 250°C, and preferably from 150 to 230°C, for from 1 to 24 hours, and preferably from 2 to 12 hours, to reduce volatile gas.

Thus, the resin film [I] having a texture integrally fabricated on the surface thereof is obtained.
The resin film [I] thus obtained has a thickness of preferably from 0.1 to 1 mm, more preferably from 0.1 to 0.7 mm, and particularly preferably from 0.1 to 0.5 mm. Where the thickness is too small, warpage after deposition of metal oxide tends to be increased. Where the thickness is too large, such a film tends to run counter to reduction in thickness and reduction in weight of a solar cell.

The resin film [I] has the fine unevenness of preferably from 10 to 300 nm, more preferably from 10 to 200 nm, and particularly preferably from 15 to 100 nm, in terms of the root mean square of surface roughness (RMS roughness) by AFM (atomic force microscope) measurement at 256 measurement points with a measurement range of 2 µm angle. Where the surface roughness is too small, the surface roughness after deposition of metal oxide may not become 10 nm or more. Where the surface roughness is too large, cracks tend to be generated in the metal oxide.

The resin film [I] according to the invention has a glass transition temperature of preferably 150°C or higher, particularly preferably 200°C or higher, and further preferably 230°C or higher. Where the glass transition temperature is too low, the temperature causes waviness of a substrate when depositing the metal oxide at high temperature. As a result, cracks are generated in the metal oxide, and sheet resistance tends to remarkably rise. The upper limit of the glass transition temperature is generally 500°C.

The resin film [I] according to the invention has a rate of saturated water absorption of preferably 3% or less, further preferably 2.5% or less, and particularly preferably 2% or less. Where the rate of saturated water absorption is too large, much time is required to achieve vacuum state when depositing the metal oxide, resulting in increase of cost. The lower limit of the rate of saturated water absorption is generally 0.01%.

The resin film [I] according to the invention has linear expansion coefficient of preferably 70 ppm/°C or less, further preferably from 40 to 70 ppm/°C, and particularly preferably from 50 to 65 ppm/°C, on the average at 50 to 150°C. Where the linear expansion coefficient is too large, the resin film [I] is deposited in the elongated state due to elevation of temperature at the time of deposition of the metal oxide. As a result, resin side shrinks at the time of cooling, thereby generating cracks in the metal oxide film, and sheet resistance tends to be remarkably increased. Furthermore, waviness tends to be generated in the resin film [I] deposited.

The resin film [I] according to the invention has flexural modulus at 150°C of preferably from 2 to 3 GPa, more preferably from 2.3 to 2.9 GPa, and further preferably from 2.5 to 2.9 GPa. Where the flexural modulus is too low, warpage and waviness are generated in the resin film due to elevation of temperature at the time of deposition of the metal oxide. As a result, further uniform metal oxide cannot be deposited, and sheet resistance tends to be increased. Where the flexural modulus is too high, physical stress due to difference in linear expansion coefficient between the metal oxide and the resin film [I] cannot be relaxed, and an electrode substrate tends to break.

The resin film [I] according to the invention has light transmittance at visible light of 550 nm of preferably 85% or more, more preferably 88% or more, and further preferably 90% or more, and further has light transmittance at 1,000 nm of preferably 85% or more, more preferably 88% or more, and further preferably 90% or more. Where the light transmittance is too low, light transmittance after deposition of the metal oxide is decreased, and photoelectric conversion efficiency tends to be decreased.

The resin film [I] according to the invention is preferably that the proportion of fluorine atom number to the sum of fluorine, carbon, nitrogen and oxygen atom numbers in the outermost layer is from 0.1 to 40% in the measurement at 1s orbit of only fluorine, carbon, nitrogen and oxygen under the measurement conditions described below in surface analysis of the resin film [I] by XPS (X-ray photoelectron spectroscopy).

### <Measurement condition>

Excited X-ray: Al Kα
X-ray voltage: 10 kV
X-ray current: 30 mA
Ar etching: None
Background treatment: Petri dish method
Where the proportion of fluorine atom number is too low, demoldability is poor and the resin film [I] tends to break when the resin film [I] is peeled from the mold. Where the proportion is too high, the deposited metal oxide tends to peel from the resin film [I].

The transparent electrode substrate for a solar cell of the invention comprises the resin film [I] obtained above and a film comprising a metal oxide fabricated thereon.

The metal oxide used in the invention is not particularly limited, and examples thereof include single metal oxides such as zinc oxide, tin oxide, indium oxide and titanium oxide; multiple metal oxides such as indium tin oxide, indium zinc oxide, indium titanium oxide and tin cadmium oxide; doping metal oxides such as gallium-doped zinc oxide, aluminum-added zinc oxide, boron-added zinc oxide, titanium-added zinc oxide, titanium-added indium oxide, zirconium-added indium oxide and fluorine-added tin oxide.
Of those, gallium-doped zinc oxide, aluminum-added zinc oxide and boron-added zinc oxide are preferred from the standpoint of low resistivity.

A method for fabricating a film comprising the metal oxide is not particularly limited. For example, it is preferred to fabricate a film comprising the metal oxide by a dry process at 150°C or higher. Where the temperature is too low, additives such as gallium, aluminum and boron are difficult to activate, crystallizability deteriorates, and sheet resistance tends to be increased. The sheet resistance is preferably 50 Ω/□ or less, more preferably 40 Ω/□ or less, and particularly preferably 30 Ω/□ or less.

The dry process used herein includes a sputtering method, a CVD method and a deposition method. In the formation of the metal oxide according to the invention, it is preferred to use a sputtering method from the point of view of adhesion with the resin film [I].

The film comprising the metal oxide has a thickness of generally from 100 to 1,000 nm, preferably from 130 to 700 nm, and particularly preferably from 150 to 500 nm. Where the thickness is too small, the sheet resistance tends to be increased. Where the thickness is too large, the deposition requires much time, and light transmittance is decreased. As a result, photoelectric conversion efficiency tends to be decreased.

The transparent electrode substrate thus obtained has a thickness of preferably from 0.1 to 1 mm, further preferably from 0.1 to 0.7 mm, and particularly preferably from 0.1 to 0.5 mm. Where the thickness is too small, the resin film [I] sags by heat at the time of fabricating the transparent electrode, and warpage and waviness tend to be generated in the electrode substrate obtained. Furthermore, cracks are liable to be generated in the transparent electrode, and low resistance tends to be not achieved. Where the thickness is too large, the thickness tends to give rise to the problem in reduction in weight and reduction in thickness of a solar cell.

The film comprising the metal oxide in the transparent electrode substrate of the invention has the root mean square of surface roughness (RMS roughness) by AFM (atomic force microscope) measurement at 256 measurement points with a measurement range of 2 µm angle, of preferably from 10 to 300 nm, particularly from 10 to 200 nm, and further preferably from 15 to 100 nm from the point of view of transmission. Where the root mean square of surface roughness (RMS roughness) is too small, sunlight is difficult to scatter, and photoelectric conversion efficiency tends to be decreased. Where the root mean square of surface roughness (RMS roughness) is too large, cracks are liable to be generated in the photoelectric conversion layer, and photoelectric conversion efficiency tends to be decreased.

The transparent electrode substrate according to the invention has a light transmittance at visible light of 550 nm of preferably 80% or more, more preferably 82% or more, and further preferably 84% or more, and further has a light transmittance at 1,000 nm of preferably 80% or more, more preferably 82% or more, and further preferably 84% or more. Where the light transmittance is too low, sunlight does not sufficiently enter the photoelectric conversion layer, and photoelectric conversion efficiency tends to be decreased.

Thus, the transparent electrode substrate of the invention is obtained. In the invention, lifting amount when the transparent electrode substrate is placed on a flat platen is preferably 5 mm or less from the point of view of deposition property of the photoelectric conversion layer, and more preferably 3 mm or less, and further preferably 2 mm or less. Where the lifting amount exceeds the above range, deposition of the photoelectric conversion layer becomes difficult. To adjust the lifting amount within the above range, for example, a resin film fabricated using the resin composition which obtains a resin film having excellent heat resistance and the plate-like molds is used.

A gas barrier film can further be fabricated on the resin film [I] according to the invention. The gas barrier film used herein means a layer which shields oxygen and moisture. The gas barrier film may be fabricated on at least one side of the resin film [I]. The gas barrier film is preferably a gas barrier film comprising silicon oxide or silicon nitride as a main component. The deposition method is not particularly limited, but a method such as deposition or sputtering is preferred.

The gas barrier film has a film thickness of preferably from 5 to 500 nm, more preferably from 10 to 100 nm, and further preferably from 15 to 50 nm. Where the film thickness is too small, gas barrier properties are not sufficient. On the other hand, where the film thickness is too large, cracks tend to be generated in the transparent electrode substrate when the substrate is bent.

As the capacity of the gas barrier properties, moisture permeability is preferably 1 g/day·atm·m² or less, more preferably 0.5 g/day·atm·m² or less, and further preferably 0.3 g/day·atm·m² or less. Where the moisture permeability is too large, reliability of a solar cell tends to be decreased. The lower limit of the moisture permeability is generally 0.0001 g/day·atm·m².

An antireflective film or an antifouling film can further be fabricated on the resin film [I] of the invention on the side opposite to the metal oxide film. It is preferred that the antireflective film is fabricated at the interface between the resin film [I] and the atmosphere. As the antireflective film, examples thereof include a fluorine resin film of low refractive index and a dielectric multilayered film having a silicon oxide film and a titanium oxide film laminated thereon. Of those, a fluorine resin film which is inexpensive and has antifouling function is preferred. The deposition method is not particularly limited, but a wet process such as spin coating or die coating is preferred.

The transparent electrode substrate according to the invention may further comprise a resin film [II] laminated on the surface of the resin film [I] on the side opposite to the metal oxide film. Namely, the transparent electrode film according to the invention may have a layer constitution of the resin film [II]/resin film [I] (texture layer)/metal oxide film.

The resin film [II] used in the invention is not particularly limited, but is desirably a resin film having excellent heat resistance, transparency and adhesion to the resin film [I] (texture layer). Use of the resin film having excellent heat resistance enables deposition at high temperature when sputtering metal oxide, and can fabricate a transparent electrode film having low sheet resistance. Furthermore, use of the resin film having excellent transparency can sufficiently transmit sunlight and can prepare a solar cell having high photoelectric conversion efficiency. Moreover, use of the resin film having excellent adhesion to the resin film [I] (texture layer) can prevent the texture layer from being peeled.

The resin film [II] used in the invention includes resins such as polyethylene terephthalate, polyethylene naphthalate, polyester, polyvinyl alcohol, polycarbonate, amorphous polyolefin, polyimide, polyurethane and polymethyl methacrylate; and resins obtained by curing compositions comprising a crosslinkable acrylic monomer and/or oligomer. Of those, polyethylene naphthalate, polyvinyl alcohol, amorphous polyolefin, polyimide, polyurethane and polymethyl methacrylate resins are preferred in heat resistance, and a polyvinyl alcohol resin having a large amount of hydroxyl groups is particularly preferred in adhesion to the resin film [I] (texture layer). The film comprising a polyvinyl alcohol resin may be a uniaxially stretched or biaxially stretched film, and a biaxially stretched polyvinyl alcohol resin film is preferred. The resin film [II] used in the invention may appropriately contain various additives such as plasticizers, antioxidants, ultraviolet absorbers, antistatic agents, flame retardants, colorants and various fillers in an amount of 20 parts by weight or less.

The resin film [II] according to the invention has a thickness of preferably from 10 to 400 µm, more preferably from 15 to 300 µm, and further preferably from 20 to 200 µm, from the point of view of handling properties at the time of production and photoelectric conversion efficiency. Where the thickness of the resin film [II] is too small, strength is insufficient. As a result, the film is liable to break, and tends to curl when the resin film [I] (texture layer) was fabricated. Where the thickness is too large, light transmittance is decreased, and there is a tendency to invite decrease in photoelectric conversion efficiency.

The resin film [II] according to the invention has a thermal deformation temperature of preferably 150°C or higher, more preferably 180°C or higher, and further preferably 200°C or higher. Where the thermal deformation temperature is too low, such low temperature results in the cause of warpage of a substrate when depositing metal oxide at high temperature. As a result, cracks tend to be generated in the metal oxide film, and sheet resistance tends to be increased. The upper limit of the thermal deformation temperature is generally 500°C.

In the transparent electrode substrate according to the invention comprising the resin film [II], the resin film [I] (texture layer) has a thickness of preferably from 0.1 to 100 µm, more preferably from 0.2 to 50 µm, and further preferably from 0.3 to 30 µm, from the point of view of photoelectric conversion efficiency. Where the thickness of the resin film [I] (texture layer) is too small, unevenness of the texture cannot sufficiently be transferred to the metal oxide film, and there is a tendency to lead to decrease in photoelectric conversion efficiency. Where the thickness is too large, breakage may be generated when bending, and there is a tendency to cause problem on photoelectric conversion. The thickness of the resin film [I] used herein means a length of from the lowest point (the outermost point) on the bottom (side opposite to the uneven surface) of the resin film [I] having uneven surface to the highest point (the outermost point) of the convex portion on the uneven surface.

In the transparent electrode substrate according to the invention comprising the resin film [II], the resin film [I] (texture layer) having unevenness obtained by photocuring the photocurable composition is fabricated on the resin film [II] to fabricate a laminate [A] comprising the resin film [I]/resin film [II], and the metal oxide film may further be fabricated on the resin film [I] (texture layer) of the laminate [A].

When the polyvinyl alcohol film is used as the resin film [II], good adhesion is maintained between the resin film [II] and the resin film [I] (texture layer), and this is preferred. Because this is obtained by photocuring the photocurable composition, there is no concern of shape deterioration after transferring such as gravure printing method using a solution, and there is no concern of low transfer precision as in the method of preparing a resin film and then imparting a texture to the surface thereof by heat or pressure. When the resin film [I] (texture layer) is fabricated by photocuring, a texture layer can be fabricated with extremely high precision, and additionally the process can be simplified.

In obtaining the laminate [A] comprising the resin film [I] (texture layer)/resin film [II], the photocurable composition is provided on the plate-like support having fine unevenness of from 10 to 300 nm in terms of the root mean square of surface roughness (RMS roughness) by AFM (atomic force microscope) measurement at 256 measurement points with a measurement range of 2 µm angle, the resin film [II] is laminated thereon, the photocurable composition is irradiated with active energy ray through the resin film [II] and/or the plate-like support to cure the photocurable composition, and the plate-like support is removed from the resin film [I] (texture layer). Thus, the laminate [A] comprising resin film [I] (texture layer)/resin film [II] can be produced.

In this case, it is necessary that the plate-like support has fine unevenness, and as the fine unevenness, the root mean square of surface roughness (RMS roughness) by AFM (atomic force microscope) measurement at 256 measurement points with a measurement range of 2 µm angle is preferably from 10 to 300 nm, more preferably from 10 to 200 nm, and further preferably from 15 to 100 nm. Where the root mean square of surface roughness (RMS roughness) is too small, the photoelectric conversion efficiency tends to be decreased. Where the root mean square of surface roughness (RMS roughness) is too large, cracks tend to be generated in the transparent electrode.

In the invention, in producing the laminate [A], the laminate [A] can be produced by, for example, continuous fabricating of roll-to-roll. In this case, a supporting resin film having a texture (unevenness) on the surface thereon may be used in place of the plate-like support. In this case, the photocurable composition is provided on the supporting resin film to be conveyed, the smooth resin film [II] conveyed at the same speed in the same direction is laminated thereon, and the photocurable composition is then irradiated with active energy ray to cure the photocurable composition. The supporting resin film having the texture is peeled, thereby the laminate [A] can be produced.

The plate-like support is not particularly limited. Plates made of glass or metal are preferred in strength and heat resistance, and a plate made of glass is particularly preferred in light transmittance property.
Specific examples of the plate-like support include the materials exemplified in the description of the plate-like mold. Furthermore, the same methods as in the plate-like mold, such as applying a release agent such as a fluorine release agent on the surface of the plate-like support, using a glass plate comprising metal oxide laminated thereon, and fabricating a thin film comprising silicon oxide or silicon nitride on the surface of metal oxide, can be used.

In the invention, the photocurable composition has a viscosity at 23°C of preferably from 5 to 5,000 mPa·s, and further preferably from 10 to 2,000 mPa·s, when adding on the plate-like support. Where the viscosity is too low or too high, it is difficult to adjust the thickness when laminating the resin film [II], and thickness accuracy tends to deteriorate.

In laminating the resin film [II], although not limited, it is easy and simple to laminate the same using a laminate roll, and it is easy to control thickness accuracy of the photocurable composition.

The ultraviolet irradiation is preferably conducted at illuminance of from 20 to 1,000 mW/cm² and particularly from 50 to 500 mW/cm², and light intensity of from 1 to 20 J/cm² and particularly from 2 to 10 J/cm², similarly as described above. After irradiation, the plate-like support is removed, and similarly as described above, the cured product obtained is heated in a vacuum oven at generally from 120 to 250°C, and preferably from 150 to 230°C, for generally from 1 to 24 hours, and preferably from 2 to 12 hours, to reduce volatile gas. Thus, the laminate [A] comprising the resin film [I] (texture layer) having unevenness on one side of the resin film [II] is obtained.

The transparent electrode substrate according to the invention comprising the resin film [II] is produced by fabricating the metal oxide film on the resin film [I] of the laminate [A] comprising the resin [I] (texture layer)/resin film [II] obtained above. The transparent electrode substrate can be produced by methods other than the above method. For example, the following method is exemplified. A photocurable composition is used, the photocurable composition is added on a plate-like support having fine unevenness, a smooth plate-like support is provided so as to face the same, and the photocurable composition is photocured by active energy ray, thereby fabricating a resin film [I] (texture layer) once. The both plate-like supports are removed, a metal oxide film is fabricated on the resin film [I] (texture layer) to obtain a laminate comprising the resin film [I] (texture layer)/metal oxide film, and a resin film [II] is laminated on the side opposite to the metal oxide film of the resin film [I] (texture layer) of the laminate. In laminating the resin film [II], a method of thermal press-bonding, and a method of laminating with an adhesive or the like, are used.

In the invention, the gas barrier film described above can further be fabricated on the laminate comprising the resin film [I] (texture layer)/resin film [II]. The gas barrier film is fabricated at least one side of the laminate [A].

The antireflective layer or antifouling layer described above can further be fabricated on the transparent electrode substrate having the layer constitution of the film comprising resin film [II]/resin film [I] (texture layer)/metal oxide film according to the invention on the resin film [II] on the side opposite to the resin film [I] (texture layer).

In the transparent electrode substrate for a solar cell of the invention comprising the resin film [II], it is preferred that the total light transmittance is 80% or more, particularly 82% or more, and further 84% or more. Where the light transmittance is too low, photoelectric conversion efficiency tends to be decreased.

The transparent electrode substrate for a solar cell of the invention has the effects being free from coloration and deformation, having excellent appearance properties free from warpage and waviness, having low resistance, and having excellent photoelectric conversion efficiency, and is therefore useful as an electrode substrate for a solar cell.

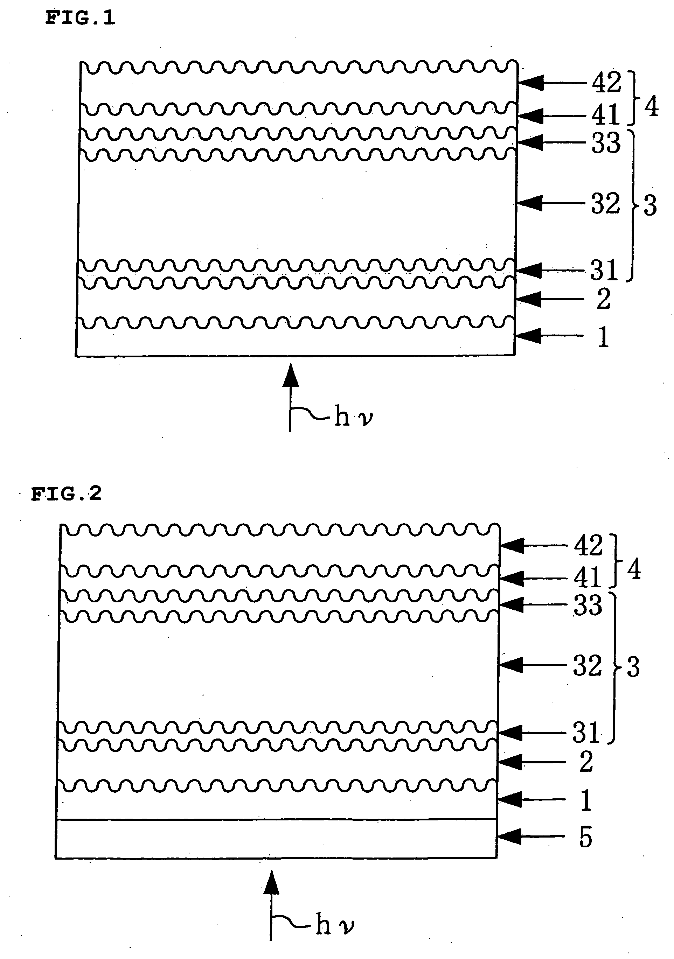

An embodiment of a solar cell using the transparent electrode substrate of the invention and a method for producing the solar cell are described below by referring to Fig. 1. An embodiment describes a super-straight type solar cell which is one of thin film silicon solar cells, but can apply to other thin film silicon solar cells such as a sub-straight type solar cell.

The constitution of the solar cell according to the invention is described.
Fig. 1 is a sectional view showing the constitution of embodiment 1 of the solar cell according to the invention, and Fig. 2 is a sectional view showing the constitution of embodiment 2 of the solar cell according to the invention. The solar cell is a super-straight type solar cell. The solar cell of the embodiment 1 comprises a resin film [I] 1, a metal oxide film 2, a photoelectric conversion layer 3 and a back reflective electrode layer 4, and the solar cell of the second embodiment further comprises a resin film [II] 5 laminated on the outer side of the resin film [I] 1. Light hλ enters the solar cell from the resin film [I] 1 side, and undergoes photoelectric conversion in the solar cell.

The photoelectric conversion layer 3 comprises p-type layer 31, i-type layer 32 and n-type layer 33.
The p-type layer 31 is fabricated on the metal oxide layer 2, and is a window layer of a solar cell. The material of the p-type layer 31 includes amorphous silicon (a-Si) containing an element belonging to Group III such as boron as impurities, amorphous silicon carbide (a-SiC), micro junction of silicon and micro junction of silicon carbide. Its thickness is a range of from 0.5 to 100 nm. The film is fabricated by at least one method selected from plasma CVD method with an atmospheric pressure or reduced pressure, a CVD method using heated catalyst, a thermal CVD method and a reactive sputtering method.
After formation of the p-type layer 31, it is preferred that a non-doped a-SiC alloy film is fabricated at a thickness in a range of from 0.5 to 20 nm as a buffer layer for inhibiting diffusion of boron into the i-type layer 32 from the p-type layer 31 in order to perform optimization of the interface between the p-type layer 31 and the i-type layer 32.

The i-type layer 32 is fabricated on the p-type layer 31. The material of the i-type layer 32 includes a-Si free from addition of impurities, micro junction of silicon, amorphous silicon germanium and micro junction of silicon germanium. Its thickness is a range of from 100 to 10,000 nm. The film is fabricated by at least one method selected from plasma CVD method with an atmospheric pressure or reduced pressure, a CVD method using heated catalyst, a thermal CVD method and a reactive sputtering method.

The n-type layer 33 is fabricated on the i-type layer 32. The material of the n-type layer 33 includes a-Si containing an element belonging to Group V such as phosphorus as impurities, a-SiC, micro junction of silicon and micro junction of silicon carbide. In the case that the n-type layer 33 is fabricated, its thickness is a range of from 0.5 to 500 nm. The film is fabricated by at least one method selected from plasma CVD method with an atmospheric pressure or reduced pressure, a CVD method using heated catalyst, a thermal CVD method and a reactive sputtering method.

The p-i-n type silicon photoelectric conversion layer 3 is fabricated through a deposition process of the silicon thin film as above. The photoelectric conversion layer 3 may be a single layer. However, when photoelectric conversion layers using the above various silicon materials in the i-type layer are laminated like p-i-n/p-i-n or p-i-n/p-i-n/p-in, further high conversion efficiency is obtained.

The back reflective electrode layer 4 has high conductivity and high reflectivity, and comprises a transparent conductive film 41 and a back metal electrode 42. The transparent conductive film 41 is fabricated on the n-type layer 33 which is the outermost layer of the photoelectric conversion layer 3, and acts to improve reflectivity of infrared ray and prevent diffusion of components of the back metal electrode 42 into the photoelectric conversion layer 3. For example, it is preferred that one comprises tin oxide, zinc oxide, indium oxide or the like as a main component.
The back metal electrode 42 is fabricated on the transparent conductive film 41. The back metal electrode 42 has high reflectivity in a region of from visible light to infrared ray, and has high conductivity. It is preferred that one is fabricated of one metal selected from Ag, Au, Al, Cu and Pt, or alloys containing those.

### Examples

The invention is described in more detail below by referring to the Examples, but the invention is not limited to the Examples as long as it does not exceed the scope of the invention.
Unless otherwise indicated, parts and % in the Examples and Comparative Examples mean by weight.
Measurement method of each of properties in Examples 1 to 7 and Comparative Examples 1 to 3 is as follows.

### (1) Root mean square of surface roughness (RMS roughness) (nm)

A sample was cut into a size of 1 cm square, and the cut sample was measured with NanoScope IIIa, manufactured by Digital Instruments. The sample is set to a horizontal sample table on a piezoscanner. A cantilever approaches the surface of the sample, and when the cantilever reached the region at which atomic force acts, the surface is scanned in XY direction. In this case, unevenness of the sample is taken as displacement in Z direction with laser. The scanner used was a scanner that can scan 150 µm in XY direction and 10 µm in Z direction. The cantilever used was a cantilever having resonance frequency of from 120 to 400 kHz and a spring constant of from 12 to 90 N/m. The surface was measured on 256 points of 2 µm × 2 µm. Scan speed was 1 Hz.

### (2) Light transmittance (%)

A sample of 3 cm square was prepared, and light transmittance (%) thereof at 550 nm and 1,000 nm was measured using a spectrophotometer V-7200, manufactured by JASCO Corporation.

### (3) Linear expansion coefficient (ppm/°C)

Using a test specimen having a length of 30 mm and a width of 3 mm, elongation (mm) of the test specimen when the temperature was elevated from 25°C to 150°C by a tensile method TMA (support distance: 20 mm, load applied: 10 g, temperature-rising rate: 5°C/min) was measured with TMA120, manufactured by Seiko Instruments Inc., and a linear expansion coefficient was calculated by the following equation. Linear expansion coefficient (ppm/°C) = Elongation (mm)/20 (mm)/125 (°C)×10⁶

### (4) Glass transition temperature (°C)

A test specimen having a length of 30 mm and a width of 3 mm was used, and glass transition temperature thereof was measured by a tensile method TMA (support distance: 20 mm, load applied: 100 g, temperature-rising rate: 5°C/min, nitrogen flow: 140 ml/min)) with TMA120, manufactured by Seiko Instruments Inc.

### (5) Rate of saturated water absorption (%)

According to JIS K7209, a test specimen having a size of 100 nm × 100 mm was dried at 50°C for 24 hours, and then dipped in water at 23°C for 10 days. The rate of water absorption (%) of the test specimen was measured.

### (6) Flexural modulus

Using a test specimen adjusted to have a length of 30 mm and a width of 3 mm, flexural modulus (GPa) thereof at 150°C was measured with FT-RHEOSPECTRA DVE-V4, manufactured by Rheology Co. In the measurement, support distance was adjusted to 20 mm, test speed was adjusted to 1.1 mm/sec, and deflection was adjusted to 4 mm.

### (7) Proportion of fluorine atom number

Using a test specimen of 8 mm × 8 mm, surface analysis was conducted by XPS (X-ray photoelectron spectroscopy apparatus XPS-7000, manufactured by Rigaku Denki Kogyo Co., Ltd.). The measurement was conducted at 1s orbit of only fluorine, carbon, nitrogen and oxygen, and the proportion of fluorine atom number to the total of fluorine, carbon, nitrogen and oxygen numbers in the outermost layer was obtained. The measurement conditions were as follows: excited X-ray: Al Kα; X-ray voltage: 10 kV; X-ray current: 30 mA; and Ar etching: none; and background treatment: Petri dish method.

### (8) Sheet resistance (Ω/□)

A test specimen of 5 cm × 5 cm was used, and sheet resistance thereof was measured using four-terminal method resistor LORESTOR MP, manufactured by Mitsubishi Chemical Corporation.

### (9) Lifting amount (warpage) (mm)

Height of the end of a transparent electrode substrate maximally separated from the face of a platen was measured in the cases that a test specimen of 5 cm × 5 cm is placed such that a metal oxide film of the transparent electrode substrate is upper and lower to the platen was measured. Thickness of the transparent electrode substrate was subtracted from the maximum value, and the value was used as a lifting amount (warpage) (mm) of the transparent electrode substrate.

### (10) Photoelectric conversion efficiency

In a solar cell of 0.5 cm × 0.5 cm (0.25 cm²), current and voltage were measured under AM (air mass) using solar simulation of 1.5 and light irradiation of 100 mW/cm², and photoelectric conversion efficiency was obtained from short-circuit current, open end voltage and fill factor.

### (11) Viscosity (mPa·s)

Viscosity was measured at 23°C and the number of revolution of 60 rpm (No. 3 rotator) using B-type visometer BISMETRON VS-A1, manufactured by Shibaura System Co., Ltd.

### <Example 1>

### [Preparation of polyfunctional urethane acrylate (A)]

53.34 g (0.24 mol) of isophorone diisocyanate, 55.73 g (0.48 mol) of 2-hydroxypropyl acrylate, 0.02 g of hydroquinone methyl ether as a polymerization inhibitor, 0.02 g of dibutyltin dilaurate as a reaction catalyst and 500 g of methyl ethyl ketone were added in a four-necked flask equipped with a thermometer, a stirrer, a water-cooling condenser and a nitrogen gas inlet, and reaction was conducted at 60°C for 3 hours. When residual isocyanate group reached 0.3%, the reaction was completed, and a solvent was distilled away to obtain bifunctional urethane acrylate (A-1).

### [Preparation of photocurable composition (B)]

40 parts of the bifunctional urethane acrylate (A-1), 30 parts of bis(hydroxymethyl)tricyclo[5.2.1.0^{2,6}]decane=dimethacrylate (DCP, manufactured by Shin-nakamura Chemical Co., Ltd.), 30 parts of pentaerythritol tetraacrylate (A-TMMT, manufactured by Shin-nakamura Chemical Co., Ltd.), 1 part of 1-hydroxycylcohexyl phenyl ketone (Irgacure 184, manufactured by Ciba Geigy) as a photopolymerization initiator and 0.5 parts of tetrakis[methylene-3-(3',5'-di-t-butyl-4-hyeroxyphenyl)propionate]methane (Irganox 1010, manufactured by Ciba Geigy) as an antioxidant were stirred at 60°C until becoming uniform to obtain a photocurable composition (B-1). The composition obtained had a viscosity of 1,500 mP·s.

### [Preparation of glass mold (C) for texture formation]

A silicon oxide film having a thickness of 100 Å was fabricated on a texture side of a glass having fabricated on one side thereof the texture comprising tin oxide (A180U80, manufactured by Asahi Glass Co., Ltd., size: 350 mm × 300 mm, root mean square of surface roughness (RMS roughness): 30 nm) by a sputtering method, and a fluorine release agent (OPTOOL DSX, manufactured by Daikin Industries, Ltd.) was uniformly applied thereto, and air-dried. It was allowed to stand under environment of 60°C and 90% RH for 3 hours, dipped in a fluorine solvent (DEMNUM SOLVENT, manufactured by Daikin Industries, Ltd.), and subjected to ultrasonic cleaning therein at 23°C for 10 minutes to obtain a glass mold (C-1) for texture formation. The texture surface has the root mean square of surface roughness (RMS roughness) of 30 nm.

### [Preparation of resin film]

Optically polished face of an optically polished glass (size: 350 mm × 300mm) and the texture face of the glass mold (C-1) for texture formation were faced inward, and a silicon plate having a thickness of 0.2 mm was used as a spacer to obtain a mold. The photocurable composition (B-1) was injected into the mold at 23°C, and irradiated with ultraviolet ray at illuminace of 200 mW/cm² and light intensity of 5 J/cm² using a metal halide lamp. The resin film thus obtained was heated in a vacuum oven at 200°C for 2 hours to obtain a resin film with a texture having a length of 300 mm, a width of 200 mm and a thickness of 0.2 mm (1 in Fig. 1).
The root mean squares of surface roughness (RMS roughness) on the texture face of the resin film with a texture obtained was 30 nm. Various properties of the resin film obtained are shown in Table 3.

### [Preparation of transparent electrode substrate]

The resin film with a texture was cut to 5 cm square, and it was subjected to ultrasonic cleaning with 1-methoxy-2-acetoxypropane, and air-dried. It was fixed to a sample holder for sputtering, and placed in a sputtering machine. The inside of the 5 sputtering machine was evacuated until reaching the pressure of 10⁻⁵ Pa, and a substrate holder temperature was set to 150°C. Argon gas was introduced into the sputtering machine at a flow rate of 100 sccm, and pressure was adjusted to 5 mTorr. Direct current power of 400W was supplied to a zinc oxide (ZnO) target having 5.7 wt% of gallium oxide (Ga₂O₃) added thereto. Thus, a transparent electrode substrate having a thin film (2 in Fig. 1) having a thickness of 200 nm and comprising gallium-doped zinc oxide fabricated on the resin film substrate (1 in Fig. 1) by sputtering was obtained. The root mean squares of surface roughness (RMS roughness) on the texture face of the transparent electrode substrate obtained was 30 nm. Various properties of the transparent electrode substrate obtained are shown in Table 4.

### [Preparation of solar cell]

The transparent electrode substrate sample obtained above was set to a three-layer separation type silicon film formation apparatus (CVD), and a photoelectric conversion layer (3 in Fig. 1) was fabricated by the following procedures.

### (Formation of p-type layer)

The sample was transported in a p-type silicon deposition chamber, and high purity semiconductor gas such as silane (SiH₄), hydrogen (H₂), diborane (B₂H₆) or methane (CH₄) was introduced into the p-type silicon deposition chamber at a constant flow rate. After maintaining a substrate temperature at 150°C and pressure at 0.5 Torr, electrical discharge was initiated to obtain a boron-doped a-Si alloy film (p-type layer 31 in Fig. 1) having a thickness of 10 nm by deposition for 1 minute. Thereafter, in the chamber, only introduction of the diborane (B₂H₆) gas in the above conditions was stopped, and a non-doped a-SiC alloy film was deposited in a thickness of 5 nm as a solar cell buffer layer. After completion of the deposition, the chamber was evacuated to high vacuum.

### (Formation of i-type layer)

The sample was then transported in an i-type silicon deposition chamber, and SiH₄ and H₂ were introduced into the i-type silicon deposition chamber at a constant flow rate.
After maintaining a substrate temperature at 150°C and high pressure at 1.0 Torr, electrical discharge was initiated to obtain a non-doped a-Si (i-type layer 32 in Fig. 1) having a thickness of 0.35 µm by deposition for 25 minutes. After completion of the deposition, the chamber was evacuated to high vacuum.

### (Formation of n-type layer)

The sample was then transported in an n-type silicon deposition chamber, and SiH₄, H₂ and phosphine (PH₃) were introduced into the n-type silicon deposition chamber at a constant flow rate. After maintaining a substrate temperature at 150°C and pressure at 0.2 Torr, electrical discharge was initiated to obtain a phosphorus-doped a-Si (n-type layer 33 in Fig. 1) having a thickness of 30 nm by deposition for 6 minutes. After completion of the deposition, the chamber was evacuated to high vacuum.

### (Formation of back reflective electrode layer)

After deposition of a photoelectric conversion unit having the above p-i-n three layers, the sample was cooled to room temperature, and taken out to the atmosphere. The sample was again placed in a sputter vacuum apparatus, and a back reflective electrode layer (4 in Fig. 1) was fabricated by the following procedures.
A gallium-doped zinc oxide layer (41 in Fig. 1) of 20 nm and a silver layer (42 in Fig. 1) of 200 nm were successively laminated at room temperature. The sample was taken out of the vacuum apparatus, and a back electrode was fabricated by patterning to obtain a solar cell having an area of 0.25 cm². Thereafter, post-annealing was conducted at 150°C for 2 hours.
As a result of measuring photoelectric conversion efficiency of an amorphous silicon solar cell obtained by the above processes, the efficiency was 8%.

### <Example 2>

### [Preparation of polyfunctional urethane acrylate (A)]

The same bifunctional urethane acrylate (A-1) as used in Example 1 was used.

### [Preparation of photocurable composition (B)]

A photocurable composition (B-2) was obtained in the same manner as in Example 1, except for using 60 parts of the bifunctional urethane acrylate (A-1), 20 parts of bis(hydroxymethyl)tricyclo[5.2.1.0^{2,6}]decane=dimethacrylate (DCP, manufactured by Shin-nakamura Chemical Co., Ltd.) and 20 parts of pentaerythritol tetraacrylate (A-TMMT, manufactured by Shin-nakamura Chemical Co., Ltd.). The composition obtained had a viscosity of 3,000 mPa·s.

### [Preparation of glass mold (C) for texture formation]

The same glass mold (C-1) for texture formation as used in Example 1 was used.

### [Preparation of resin film]

A resin film with a texture was obtained in the same manner as in Example 1 except for using the photocurable resin (B-2). Various properties of the resin film with a texture obtained are shown in Table 3.

### [Preparation of transparent electrode substrate]

A transparent electrode substrate was obtained in the same manner as in Example 1, except for using the resin film obtained above. Various properties of the transparent electrode substrate obtained are shown in Table 4.

### [Preparation of solar cell]

An amorphous silicon solar cell was prepared in the same manner as in Example 1, except for using the transparent electrode substrate obtained above. As a result of measuring photoelectric conversion efficiency, the efficiency was 7%.

### <Example 3>

### [Preparation of polyfunctional urethane acrylate (A)]

The same bifunctional urethane acrylate (A-1) as used in Example 1 was used.

### [Preparation of photocurable composition (B)]

The same photocurable composition (B-1) as used in Example 1 was used.

### [Preparation of glass mold (C) for texture formation]

The same glass mold (C-1) for texture formation as used in Example 1 was used.

### [Preparation of resin film]

A resin film with texture was obtained in the same manner as in Example 1. Various properties of the resin film with a texture obtained are shown in Table 3.

### [Preparation of transparent electrode substrate]

A transparent electrode substrate was obtained in the same manner as in Example 1, except that the thickness of the metal oxide film was changed to 100 nm. Various properties of the transparent electrode substrate obtained are shown in Table 4.

### [Preparation of solar cell]

An amorphous silicon solar cell was prepared in the same manner as in Example 1, except for using the transparent electrode substrate obtained above. As a result of measuring photoelectric conversion efficiency, the efficiency was 8%.

### <Example 4>

### [Preparation of polyfunctional urethane acrylate (A)]

The same bifunctional urethane acrylate (A-1) as used in Example 1 was used.

### [Preparation of photocurable composition (B)]

The same photocurable composition (B-1) as used in Example 1 was used.

### [Preparation of glass mold (C) for texture formation]

A glass mold (C-2) for texture formation was obtained in the same manner as in Example 1, except for using a glass substrate having a texture comprising tin oxide fabricated on one side thereof, having a size of 300 nm × 350 mm and the root mean square of surface roughness (RMS roughness) of 20 nm. The root mean square of surface roughness (RMS roughness) on the texture face was 20 nm.

### [Preparation of resin film]

A resin film with a texture was obtained in the same manner as in Example 1, except for using the glass mold (C-2) for texture formation. Various properties of the resin film with a texture obtained are shown in Table 3.

### [Preparation of transparent electrode substrate]

A transparent electrode substrate was obtained in the same manner as in Example 1, except for using the resin film obtained above. Various properties of the transparent electrode substrate obtained are shown in Table 4.

### [Preparation of solar cell]

An amorphous silicon solar cell was prepared in the same manner as in Example 1, except for using the transparent electrode substrate obtained above. As a result of measuring photoelectric conversion efficiency, the efficiency was 7%.

### <Example 5>

### [Preparation of polyfunctional urethane acrylate (A)]

The same bifunctional urethane acrylate (A-1) as used in Example 1 was used.

### [Preparation of photocurable composition (B)]

The same photocurable composition (B-1) as used in Example 1 was used.

### [Preparation of glass mold (C) for texture formation]

The same glass mold (C-1) for texture formation as used in Example 1 was used.

### [Preparation of resin film]

A resin film with a texture was obtained in the same manner as in Example 1, except for using a silicon plate having a thickness of 1mm as a spacer. Various properties of the resin film with a texture obtained are shown in Table 3.

### [Preparation of transparent electrode substrate]

A transparent electrode substrate was obtained in the same manner as in Example 1, except for using the resin film obtained above. Various properties of the transparent electrode substrate obtained are shown in Table 4.

### [Preparation of solar cell]

An amorphous silicon solar cell was prepared in the same manner as in Example 1, except for using the transparent electrode substrate obtained above. As a result of measuring photoelectric conversion efficiency, the efficiency was 9%.

### <Example 6>

### [Preparation of polyfunctional urethane acrylate (A)]

53.34 g (0.24 mol) of isophorone diisocyanate, 95.46 g (0.48 mol) of pentaerythritol triacrylate (hydroxyl value: 125.4 mg KOH/g) (VISCOAT #300, manufactured by Osaka Organic Chemical Industry Ltd.), 0.02 g of hydroquinone methyl ether as a polymerization inhibitor, 0.02 g of dibutyltin dilaurate as a reaction catalyst and 500 g of methyl ethyl ketone were added in a four-necked flask equipped with a thermometer, a stirrer, a water cooling condenser and a nitrogen gas inlet, and reaction was conducted at 60°C for 3 hours. When residual isocyanate group reached 0.3%, the reaction was completed, and a solvent was distilled away to obtain hexafunctional urethane acrylate (A-2).

### [Preparation of photocurable composition (B)]

A photocurable composition (B-3) was obtained in the same manner as in Example 1, except for using 10 parts of the hexafunctional urethane acrylate and 90 parts of bis(hydroxymethyl)tricyclo[5.2.1.0^{2,6}]decane=dimethacrylate (DCP, manufactured by Shin-nakamura Chemical Co., Ltd.). The photocurable composition (B-3) obtained had a viscosity of 400 mPa·s.

### [Preparation of glass mold (C) for texture formation]

The same glass mold (C-1) for texture formation as used in Example 1 was used.

### [Preparation of resin film]

A resin film with a texture was obtained in the same manner as in Example 1, except for using the photocurable composition (B-3) obtained above. Various properties of the resin film with a texture obtained are shown in Table 3.

### [Preparation of transparent electrode substrate]

A transparent electrode substrate was obtained in the same manner as in Example 1, except for using the resin film obtained above. Various properties of the transparent electrode substrate obtained are shown in Table 4.

### [Preparation of solar cell]

An amorphous silicon solar cell was prepared in the same manner as in Example 1, except for using the transparent electrode substrate obtained above. As a result of measuring photoelectric conversion efficiency, the efficiency was 8%.

### <Example 7>

### [Preparation of polyfunctional urethane acrylate (A)]

The same bifunctional urethane acrylate (A-1) as used in Example 1 was used.

### [Preparation of photocurable composition (B)]

The same photocurable composition (B-1) as used in Example 1 was used.

### [Preparation of glass mold (C) for texture formation]

The same glass mold (C-1) for texture formation as used in Example 1 was used.

### [Preparation of resin film]

A resin film with a texture was obtained in the same manner as in Example 1. Furthermore, a silicon oxide film was fabricated at a thickness of 20 nm on the face opposite to the texture of the resin film by a sputtering method, thereby fabricating a gas barrier film. Various properties of the resin film with a gas barrier film and a texture obtained are shown in Table 3.

### [Preparation of transparent electrode substrate]

A transparent electrode substrate was obtained in the same manner as in Example 1, except for using the resin film obtained above. Various properties of the transparent electrode substrate obtained are shown in Table 4.

### [Preparation of solar cell]

An amorphous silicon solar cell was prepared in the same manner as in Example 1, except for using the transparent electrode substrate obtained above. As a result of measuring photoelectric conversion efficiency, the efficiency was 8%.

### <Comparative Example 1>

### [Preparation of resin film]

A polycarbonate film having a length of 400 mm, a width of 300 mm and a thickness of 0.2 mm, and a glass (A180U80, manufactured by Asahi Glass Co., Ltd., size: 400 mm x 300 mm) having a texture comprising ZnO fabricated on the one side thereof, placed on the polycarbonate film, were placed on a table of a press machine having a press table of 500 mm x 500 mm such that the texture face faces down, and hot press was conducted at 200°C for 10 minutes to obtain a resin film with a texture.
The root mean square of surface roughness (RMS roughness) on the texture face of the resin film obtained was 10 nm, and 30 nm of the root mean square of surface roughness (RMS roughness) of the glass with a texture used in heat transfer could not precisely be transferred. Various properties of the resin film are shown in Table 3.

### [Preparation of transparent electrode substrate]

A transparent electrode substrate was obtained in the same manner as in Example 1, except for using the resin film obtained above. Various properties of the transparent electrode substrate obtained are shown in Table 4.

### [Preparation of solar cell]

An amorphous silicon solar cell was prepared in the same manner as in Example 1, except for using the transparent electrode substrate obtained above. As a result of measuring photoelectric conversion efficiency, the efficiency was 1%.

### <Comparative Example 2>

### [Preparation of polyfunctional urethane acrylate (A)]

The same bifunctional urethane acrylate (A-1) as used in Example 1 was used.

### [Preparation of photocurable composition (B)]

The same photocurable composition (B-1) as used in Example 1 was used.

### [Preparation of glass mold (C) for texture formation]

A smooth blue sheet glass (root mean square of surface roughness (RMS roughness)=2 nm) was used.

### [Preparation of resin film]

A resin film without texture was obtained in the same manner as in Example 1, except for using the blue sheet glass above. Various properties of the resin film obtained are shown in Table 3.

### [Preparation of transparent electrode substrate]

A transparent electrode substrate was obtained in the same manner as in Example 1, except for using the resin film obtained above. Various properties of the transparent electrode substrate obtained are shown in Table 4.

### [Preparation of solar cell]

An amorphous silicon solar cell was prepared in the same manner as in Example 1, except for using the transparent electrode substrate obtained above. As a result of measuring photoelectric conversion efficiency, the efficiency was 4%.

### <Comparative Example 3>

### [Preparation of transparent electrode substrate]

A glass substrate with SnO₂ having a texture (A110U80, manufactured by Asahi Glass Co., Ltd.) was cut to 5 cm square. It was fixed to a sample holder for sputtering, and placed in a sputtering machine. The inside of the sputtering machine was evacuated until reaching the pressure of 10⁻⁵ Pa, and a substrate holder temperature was set to 200°C. Argon gas was introduced into the sputtering machine at a flow rate of 100 sccm, and pressure was adjusted to 5 mTorr. Direct current power of 400W was supplied to a zinc oxide (ZnO) target having 5.7 wt% of gallium oxide (Ga₂O₃) added thereto. Thus, a transparent electrode substrate having a thin film (2 in Fig. 1) comprising gallium-doped zinc oxide, and having a thickness of 20 nm fabricated on the glass substrate with SnO₂ by sputtering was obtained. The weight of the transparent electrode substrate was 6 g, and was much larger than the weight of a transparent electrode substrate using a resin film. Various properties of the transparent electrode substrate obtained are shown in Table 4.

### [Preparation of solar cell]

An amorphous silicon solar cell was prepared in the same manner as in Example 1, except for using the transparent electrode substrate obtained above. As a result of measuring photoelectric conversion efficiency, the efficiency was 10%.

The results of Examples 1 to 7 and Comparative Examples 1 to 3 are shown in Tables 1 to 4.

**TABLE 1**

| <Photocurable composition> | | | | | |
|---|---|---|---|---|---|
| | Photocurable composition | Urethane (meth)acrylate | Polyfunctional (meth)acrylate 1 | Polyfunctional (meth)acrylate 2 | Photopolymerization initiator |
| Example 1 | B-1 | A-1 | DCP | A-TMMT | Irgacure 184 |
| | | 40 parts | 30 parts | 30 parts | 1 part |
| Example 2 | B-2 | A-1 | DCP | A-TMMT | Irgacure 184 |
| | | 60 parts | 20 parts | 20 parts | 1 part |
| Example 3 | B-1 | A-1 | DCP | A-TMMT | Irgacure 184 |
| | | 40 parts | 30 parts | 30 parts | 1 part |
| Example 4 | B-1 | A-1 | DCP | A-TMMT | Irgacure 184 |
| | | 40 parts | 30 parts | 30 parts | 1 part |
| Example 5 | B-1 | A-1 | DCP | A-TMMT | Irgacure 184 |
| | | 40 parts | 30 parts | 30 parts | 1 part |
| Example 6 | B-3 | A-2 | DCP | - | Irgacure 184 |
| | | 10 parts | 90 parts | | 1 part |
| Example 7 | B-1 | A-1 | DCP | A-TMMT | Irgacure 184 |
| | | 40 parts | 30 parts | 30 parts | 1 part |
| Comparative Example 1 | (Polycarbonate) | | | | |
| Comparative | B-1 | A-1 | DCP | A-TMMT | Irgacure 184 |
| Example 2 | | 40 parts | 30 parts | 30 parts | 1 part |
| Comparative Example 3 | - | - | - | - | - |

**TABLE 2**

| <Glass mold> | | | | |
|---|---|---|---|---|
| | Surface treatment 1 | | Surface treatment 2 | RMS roughness |
| Example 1 | SiO₂ | 100 Å | OPTOOL DSX | 30 |
| Example 2 | SiO₂ | 100 Å | OPTOOL DSX | 30 |
| Example 3 | SiO₂ | 100 Å | OPTOOL DSX | 30 |
| Example 4 | SiO₂ | 100 Å | OPTOOL DSX | 20 |
| Example 5 | SiO₂ | 100 Å | OPTOOL DSX | 30 |
| Example 6 | SiO₂ | 100 Å | OPTOOL DSX | 30 |
| Example 7 | SiO₂ | 100 Å | OPTOOL DSX | 30 |
| Comparative Example 1 | - | | - | 30 |
| Comparative Example 2 | - | | - | 2 |
| Comparative Example 3 | - | | - | - |

**TABLE 3**

| <Resin film (texture layer) [I]> | | | | | | | | | | |
|---|---|---|---|---|---|---|---|---|---|---|
| | Resin Thickness (mm) | Gas Barrier film (mm) | RMS roughness (nm) | Light transmittance (%) | | Linear Expansion coefficient (ppm/°C) | Glass Transition temperature (°C) | Rate of saturated water absorption (%) | Flexural modulus (GPa) | Fluorine atom number (%) |
| | | | | 550 nm | 1000 nm | | | | | |
| Example 1 | 0.2 | - | 30 | 91 | 91 | 65 | 230 | 2 | 2.9 | 26 |
| Example 2 | 0.2 | - | 30 | 91 | 91 | 70 | 210 | 2 | 2.5 | 27 |
| Example 3 | 0.2 | - | 30 | 91 | 91 | 65 | 230 | 2 | 2.9 | 22 |
| Example 4 | 0.2 | - | 20 | 91 | 91 | 65 | 230 | 2 | 2.9 | 30 |
| Example 5 | 1.0 | - | 30 | 90 | 90 | 65 | 230 | 2 | 2.9 | 25 |
| Example 6 | 0.2 | - | 30 | 91 | 91 | 56 | 230 | 1 | 2.5 | 27 |
| Example 7 | 0.2 | 20 | 30 | 90 | 90 | 65 | 230 | 2 | 2.9 | 25 |
| Comparative Example 1 | 0.2 | - | 10 | 85 | 85 | 75 | 150 | 2 | 2.2 | 0 |
| Comparative Example 2 | 0.2 | - | 2 | 91 | 91 | 65 | 230 | 2 | 2.9 | 0 |
| Comparative Example 3 | 1.1 (Glass) | - | 30 | 88 | 88 | 7 | >500 | - | - | 0 |

**TABLE 4**

| <Transparent electrode substrate and solar cell> | | | | | | | | | | |
|---|---|---|---|---|---|---|---|---|---|---|
| | Transparent electrode substrate | | | | | | | | | Solar cell |
| | Transparent electrode | | | RMS roughness (nm) | Light transmittance (%) | | Warpage (Lifting amount) (mm) | Weight (g) | Sheet resistance (Ω/□) | Photoelectric conversion efficiency (%) |
| | Material | Film thickness(nm) | Deposition temperature (°C) | | 550 (nm) | 1000 (nm) | | | | |
| Example 1 | Gallium-doped zinc oxide | 200 | 200 | 30 | 86 | 86 | 1 | 0.6 | 30 | 8 |
| Example 2 | Gallium-doped zinc oxide | 200 | 200 | 30 | 86 | 86 | 2 | 0.6 | 30 | 7 |
| Example 3 | Gallium-doped zinc oxide | 100 | 200 | 30 | 87 | 87 | 1 | 0.6 | 40 | 8 |
| Example 4 | Gallium-doped zinc oxide | 200 | 200 | 20 | 86 | 86 | 1 | 0.6 | 30 | 7 |
| Example 5 | Gallium-doped zinc oxide | 200 | 200 | 30 | 85 | 85 | 0 | 3 | 30 | 9 |
| Example 6 | Gallium-doped zinc oxide | 200 | 200 | 30 | 86 | 86 | 1 | 0.6 | 30 | 8 |
| Example 7 | Gallium-doped zinc oxide | 200 | 200 | 30 | 86 | 86 | 1 | 0.6 | 30 | 8 |
| Comparative Example 1 | Gallium-doped zinc oxide | 200 | 200 | 10 | 80 | 80 | 10 | 0.6 | 1000 | 1 |
| Comparative Example 2 | Gallium-doped zinc oxide | 200 | 200 | 2 | 86 | 86 | 2 | 0.6 | 40 | 4 |
| Comparative Example 3 | Tin oxide + Gallium-doped zinc oxide | 20 (Zinc oxide) | 200 | 30 | 85 | 85 | 0 | 6 | 5 | 10 |

Examples regarding a solar cell using a transparent electrode substrate of the embodiment 2 are described below. Measurement method of each of properties in Examples 8 to 10 and Comparative Examples 3 and 4 is as follows.

### (12) Light transmittance (%)

A sample of 3 cm square was prepared, and the total light transmittance (%) thereof was measured using a spectrophotometer (V-7200, manufactured by JASCO Corporation).

### (13) Thermal deformation temperature (°C)

A test specimen having a length of 30 mm and a width of 3 mm was used. Temperature was elevated from room temperature by a tensile method TMA (support distance: 20 mm, load applied: 100 g, temperature-rising rate: 5°C/min) with TMA120, manufactured by Seiko Instruments Inc., and when the amount of elongation reached 200% (40 mm), the temperature was set as a thermal deformation temperature.

### (14) Adhesion between resin film [II] and texture layer

Cellophane tape was adhered on a texture layer, and adhesion when the cellophane tape was subjected to 180° peel test at a rate of 10 cm/sec was evaluated. The state that the resin film and the texture layer were peeled was indicated "B", and the state that the resin film and the texture layer were not peeled was indicated "A".

### <Example 8>

### [Preparation of polyfunctional urethane acrylate (A)]

The same bifunctional urethane acrylate (A-1) as used in Example 1 was used.

### [Preparation of photocurable composition (B)]

The same photocurable composition (B-1) as used in Example 1 was used.

### [Preparation of support (C) for texture formation]

The same glass mold (C-1) for texture formation as used in Example 1 was used as a support (C) for texture formation.

### [Preparation of laminate [A] comprising resin film [I] (texture layer)/resin film [II]]

The texture face of the support (C-1) for texture formation was faced upward, and 2 g of the photocurable composition (B-1) was uniformly dropped in linear state at 23°C to the part 2-cm inside from the edge of one side of the support. A polyvinyl alcohol film (BOVLON, manufactured by Nippon Synthetic Chemical Industry Co., Ltd., size: 350 mm x 300 mm, thickness: 25 µm) as a resin film [II] was laminated on the entire surface of the photocurable composition face by a laminating machine. The lamination speed was 0.5 m/min. Ultraviolet irradiation at illuminance of 200 mW/cm² and light intensity of 5 J/cm² was conducted from the side of the polyvinyl alcohol film using a metal halide lamp, and the support was removed to obtain a laminate [A] (1 and 5 in Fig. 2) having a length of 350 mm and a width of 300 mm, and comprising resin the film [I] (texture layer)/resin film [II].
The resin film [I] (texture layer) had a thickness of 10 µm, and peeling of the resin film [I] was not generated.
Various properties of the laminate [A] obtained are shown in Table 5.

### [Preparation of transparent electrode substrate]

A transparent electrode substrate was obtained in the same manner as in Example 1, except for using the laminate [A] obtained above. Various properties of the transparent electrode substrate obtained are shown in Table 6.

### [Preparation of solar cell]

An amorphous silicon solar cell was prepared in the same manner as in Example 1, except for using the transparent electrode substrate obtained above. As a result of measuring photoelectric conversion efficiency, the efficiency was 8%.

### <Example 9>

### [Preparation of polyfunctional urethane acrylate (A)]

The same bifunctional urethane acrylate (A-1) as used in Example 1 was used.

### [Preparation of photocurable composition (B)]

The same photocurable composition (B-1) as used in Example 1 was used.

### [Preparation of support (C) for texture formation]

A silicon oxide film having a thickness of 100 Å was fabricated on the texture face of a glass having unevenness (texture) comprising tin oxide fabricated on one side thereof (size: 350 mm x 300 mm, the root mean square of surface roughness (RMS roughness): 25 nm) by a sputtering method, and a fluorine release agent (OPTOOL DSX, manufactured by Daikin Industries, Ltd.) was uniformly applied thereto, and air-dried. It was then allowed to stand under environment of 60°C and 90% RH for 3 hours, dipped in a fluorine solvent (DEMNUM SOLVENT, manufactured by Daikin Industries, Ltd.), and subjected to ultrasonic cleaning therein at 23°C for 10 minutes to obtain a support (C-2) for texture formation. The root mean square of surface roughness (RMS roughness) of the texture face was 25 nm.

### [Preparation of laminate [A] comprising resin film [I] (texture layer)/resin film [II]]

A laminate [A] was obtained in the same manner as in Example 8, except for using (C-2) obtained above as the support for texture formation. Various properties of the laminate [A] obtained are shown in Table 5.

### [Preparation of transparent electrode substrate]

A transparent electrode substrate was obtained in the same manner as in Example 1, except for using the laminate [A] obtained above. Various properties of the transparent electrode substrate obtained are shown in Table 6.

### [Preparation of solar cell]

An amorphous silicon solar cell was prepared in the same manner as in Example 1, except for using the transparent electrode substrate obtained above. As a result of measuring photoelectric conversion efficiency, the efficiency was 7%.

### <Example 10>

### [Preparation of polyfunctional urethane acrylate (A)]

The same hexafunctional urethane acrylate (A-2) as used in Example 6 was used.

### [Preparation of photocurable composition (B)]

A photocurable composition (B-2) was obtained in the same manner as in Example 1, except for using 40 parts of the hexafunctional urethane acrylate (A-2), 40 parts of bis(hydroxymethyl)tricyclo[5.2.1.0^{2,6}]decane=dimethacrylate (DCP, manufactured by Shin-nakamura Chemical Co., Ltd.) and 20 parts of tricyclodecyl acrylate (FA-513A, manufactured by Hitachi Chemical Co., Ltd.). The photocurable composition (B-2) obtained had a viscosity of 500 mPa·s.

### [Preparation of support (C) for texture formation]

The same glass mold (C-1) for texture formation as used in Example 1 was used as a support (C) for texture formation.

### [Preparation of laminate [A] comprising resin film [I] (texture layer)/resin film [II]]

A laminate [A] was obtained in the same manner as in Example 8. Various properties of the laminate [A] obtained are shown in Table 5.

### [Preparation of transparent electrode substrate]

A transparent electrode substrate was obtained in the same manner as in Example 1, except for using the laminate [A] obtained above. Various properties of the transparent electrode substrate obtained are shown in Table 6.

### [Preparation of solar cell]

An amorphous silicon solar cell was prepared in the same manner as in Example, except for using the transparent electrode substrate obtained above. As a result of measuring photoelectric conversion efficiency, the efficiency was 8%.

### <Comparative Example 4>

### [Preparation of support (C) for texture formation]

The same support (C-1) for texture formation as used in Example 8 was used.

### [Preparation of laminate comprising resin film/texture layer having unevenness]

The texture face of the support (C-1) for texture formation was faced upward, and a polyethylene film having a thickness of 0.1 mm was pressed on the texture face at 130°C. A polyvinyl alcohol film (BOVLON, manufactured by Nippon Synthetic Chemical Industry Co., Ltd., size: 350 mm x 300 mm, thickness: 25 µm) as a resin film was laminated on the polyethylene film at 100°C. The lamination speed was 0.5 m/min. The support was removed to obtain a laminate having a length of 350 mm and a width of 300 mm comprising the resin film/texture layer. The laminate obtained was a laminate in which the texture is not beautifully transferred. Various properties of the laminate obtained are shown in Table 5.

### [Preparation of transparent electrode substrate]

Preparation of a transparent electrode substrate was conducted in the same manner as in Example 1, except for using the laminate obtained above. However, the texture layer melted by sputtering at 150°C, and a transparent electrode substrate could not be prepared.

The results of Examples 8 to 10 and Comparative Examples 3 and 4 are shown in Tables 5 and 6.

**TABLE 5**

| <Resin film (texture layer) [I] and resin film [II]> | | | | | | | |
|---|---|---|---|---|---|---|---|
| | Resin film (texture layer) [I] | | | Resin film [II] | | | Adhesion between texture layer [I] and resin film [II] |
| | Composition | Thickness (µm) | RMS roughness (nm) | Resin film | Thickness (µm) | Thermal deformation temperature (°C) | |
| Example 8 | B-1 | 10 | 30 | BOVLON | 25 | 220 | A |
| Example 9 | B-1 | 10 | 25 | BOVLON | 25 | 220 | A |
| Example 10 | B-2 | 10 | 30 | BOVLON | 25 | 220 | A |
| Comparative Example 3 | - | - | 30 | (Glass) | (Glass) (1.1 mm) | >500 | - |
| Comparative Example 4 | (Polyethylene) | (100) | 15 | BOVLON | 25 | 220 | A |

**TABLE 6**

| <Transparent electrode substrate and solar cell> | | | | |
|---|---|---|---|---|
| | Transparent electrode substrate | | | Solar cell |
| | Total Light transmittance (%) | Weight (g) | Sheet Resistance (Ω/□) | Photoelectric conversion efficiency (%) |
| Example 8 | 86 | 0.1 | 30 | 8 |
| Example 9 | 86 | 0.1 | 30 | 7 |
| Example 10 | 86 | 0.1 | 30 | 8 |
| Comparative Example 3 | 86 | 6 | 5 | 10 |
| Comparative Example 4 | - | - | - | - |

### Industrial Applicability

The transparent electrode substrate for a solar cell of the invention is free from coloration and deformation, has excellent appearance properties free from warpage and waviness, has low resistance, and has excellent effect in photoelectric conversion efficiency, and is therefore useful as an electrode substrate for a solar cell.

## Claims

1. A transparent electrode substrate for a solar cell comprising a resin film [I] and a film comprising a metal oxide fabricated thereon, wherein the resin film [I] is a fabricated body obtained by curing a photocurable composition and having an unevenness on the side of the resin film [I] on which the film comprising a metal oxide is fabricated.

2. The transparent electrode substrate for a solar cell according to claim 1, wherein the photocurable composition comprises a polyfunctional (meth)acrylate compound and a photopolymerization initiator.

3. The transparent electrode substrate for a solar cell according to claim 1, wherein the resin film [I] has a thickness of from 0.1 to 1 mm, and the unevenness of the resin film [I] is from 10 to 300 nm in terms of root mean square of surface roughness (RMS roughness) by AFM (atomic force microscope) measurement at 256 measurement points with a measurement range of 2 µm angle.

4. The transparent electrode substrate for a solar cell according to claim 1, wherein the resin film [I] satisfies the following two requirements:
(1) a glass transition temperature is 150°C or higher, and
(2) a rate of saturated water absorption is 3% or less.

5. The transparent electrode substrate for a solar cell according to claim 1, wherein the resin film [I] satisfies the following two requirements:
(1) an average linear expansion coefficient at 50 to 150°C is 70 ppm/°C or less, and
(2) a flexural modulus at 150°C is from 2 to 3 GPa.

6. The transparent electrode substrate for a solar cell according to claim 1, wherein the resin film [I] satisfies the following two requirements:
(1) a light transmittance at 550 nm of visible light is 85% or more, and
(2) a light transmittance at 1,000 nm of near infrared light is 85% or more.

7. The transparent electrode substrate for a solar cell according to claim 1, which satisfies the following two requirements:
(1) a light transmittance at 550 nm of visible light is 80% or more, and
(2) a light transmittance at 1,000 nm of near infrared light is 80% or more.

8. The transparent electrode substrate for a solar cell according to claim 1, wherein root mean square of surface roughness (RMS roughness) by AFM (atomic force microscope) measurement at 256 measurement points with a measurement range of 2 µm angle on the surface of the film comprising a metal oxide is from 10 to 300 nm.

9. The transparent electrode substrate for a solar cell according to claim 1, which further comprises a gas barrier film fabricated on at least one side of the resin film [I], wherein the gas barrier film has a thickness of from 5 to 500 nm and comprises a silicon oxide or silicon nitride as a main component.

10. The transparent electrode substrate for a solar cell according to claim 1, wherein a lifting amount is 5 mm or less when the transparent electrode substrate is placed on a flat platen.

11. The transparent electrode substrate for a solar cell according to claim 1, wherein the resin film [I] is obtained by:
(1) facing a pair of plate-like molds at a given distance, in which an active energy ray passes through at least one mold and at least one mold has a fine unevenness of from 10 to 300 nm in terms of root mean square of surface roughness (RMS roughness) by AFM (atomic force microscope) measurement at 256 measurement points with a measurement range of 2 µm angle, and sealing a surrounding part thereof to fabricate a mold cavity, and
(2) injecting the photocurable composition into the cavity, irradiating the photocurable composition with the active energy ray through the plate-like mold to cure the photocurable composition, and then demolding a fabricated body of the photocured resin from the plate-like mold.

12. The transparent electrode substrate for a solar cell according to claim 1, which further comprises a resin film [II] laminated on the resin film [I] on the side opposite to the film comprising a metal oxide.

13. The transparent electrode substrate for a solar cell according to claim 12, wherein the resin film [I] has a thickness of from 0.1 to 100 µm, and the resin film [II] has a thickness of from 10 to 400 µm.

14. The transparent electrode substrate for a solar cell according to claim 12, wherein the resin film [II] has a thermal deformation temperature of 150°C or higher.

15. The transparent electrode substrate for a solar cell according to claim 12, wherein the resin film [II] is a polyvinyl alcohol film.

16. The transparent electrode substrate for a solar cell according to claim 12, which has a total light transmittance of 80% or more.

17. The transparent electrode substrate for a solar cell according to claim 12, which further comprises a gas barrier film fabricated on at least one side of a laminate [A] comprising the resin film [I]/resin film [II], wherein the gas barrier film has a thickness of from 5 to 500 nm and comprises a silicon oxide or silicon nitride as a main component.

18. The transparent electrode substrate for a solar cell according to claim 12, wherein the laminate [A] comprising the resin film [I]/resin film [II] is obtained by adding the photocurable composition on a plate-like support having an unevenness of from 10 to 300 nm in terms of root mean square of surface roughness (RMS roughness) by AFM (atomic force microscope) measurement at 256 measurement points with a measurement range of 2 µm angle, laminating the resin film [II] thereon, irradiating the photocurable composition with the active energy ray through the resin film [II] and/or the plate-like support to cure the photocurable composition, and then removing the plate-like support.
